# FASCICULE DE BREVET EUROPEEN

(11) **EP 4 341 202 B1**
(45) Date de publication et mention de la délivrance du brevet: **09.04.2025**
(21) Numéro de dépôt: 22731744.3
(22) Date de dépôt: 20.05.2022
(51) Int. Cl.: B81B 3/00, H02N 1/00

(54) **MICROSYSTEME ELECTROMECANIQUE PERMETTANT DE DEPLACER UNE PIECE MECANIQUE SELON DEUX SENS OPPOSES**
ELEKTROMECHANISCHES MIKROSYSTEM ZUM BEWEGEN EINES MECHANISCHEN TEILS IN ZWEI ENTGEGENGESETZTE RICHTUNGEN
ELECTROMECHANICAL MICROSYSTEM FOR MOVING A MECHANICAL PART IN TWO OPPOSITE DIRECTIONS

(30) Priorité: 21.05.2021 FR 2105346
(43) Date de publication de la demande: 27.03.2024
(73) Titulaire: Silmach, 25000 Besançon (FR); Centre National de la Recherche Scientifique (CNRS), 75016 Paris (FR); UNIVERSITE DE FRANCHE COMTE, 25000 Besancon (FR)
(72) Inventeur: CÔTE, Thierry, 25660 GENNES (FR); MINOTTI, Patrice, 25660 GENNES (FR); BOURBON, Gilles, 25000 BESANÇON (FR); LE, MOAL Patrice, 25000 BESANÇON (FR)
(74) Mandataire: Regimbeau
(86) Numéro de dépôt international: PCT/FR2022/050964
(87) Numéro de publication internationale: WO 2022/243645

(56) Documents cités:
- US-A- 5 998 906

## Description

### DOMAINE DE L'INVENTION

L'invention concerne le domaine des microsystèmes électromécaniques.

### ETAT DE LA TECHNIQUE

Les microsystèmes électromécaniques (ou MEMS) sont des systèmes mécaniques miniatures fabriqués par gravure à partir d'un matériau semi-conducteur. Ces microsystèmes comprennent des pièces mécaniques présentant des dimensions micrométriques et utilisent l'électricité comme source d'énergie pour fonctionner.

Le document FR 2 874 907 décrit par exemple un dispositif d'entrainement formé par gravure dans une plaquette en matériau semi-conducteur, tel que par exemple du silicium. Le dispositif d'entrainement comprend une dent d'entrainement apte à engrener séquentiellement avec une roue dentée, et un actionneur composé d'un premier module élémentaire propre à déplacer la dent d'entrainement selon une première direction (direction radiale) et un deuxième module élémentaire propre à déplacer la dent selon une deuxième direction (direction tangentielle) par rapport à la roue dentée. Le premier module élémentaire et le deuxième module élémentaire sont des modules électrostatiques présentant une structure à peignes interdigités.

Le premier module élémentaire et le deuxième module élémentaire sont commandés au moyen de signaux d'adressage alternatifs déphasés, de manière à déplacer la dent d'entrainement selon un mouvement cyclique avec une trajectoire en hystérésis. Au cours de ce mouvement cyclique, la dent d'entrainement alterne entre des phases d'entrainement et des phases de débrayage. A chaque cycle, la dent d'entrainement engrène avec une dent de la roue et fait tourner la roue dentée d'un pas. Les cycles sont répétés de sorte que la dent d'entrainement engrène avec des dents successives de la roue dentée, et par conséquent entraine la roue dentée dans un mouvement de rotation pas à pas.

Au cours de la phase d'entrainement, la dent d'entrainement est déplacée sous l'effet des forces électrostatiques générées par les peignes interdigités. En revanche, au cours de la phase de débrayage, la dent d'entrainement est déplacée en sens inverse sous l'effet de forces élastiques de rappel générées par des suspensions des peignes interdigités.

Un tel dispositif d'entrainement présente l'avantage qu'il peut être utilisé pour entrainer une roue dentée d'un mécanisme de montre, en remplacement des moteurs de montre traditionnels, et permet généralement de réduire le nombre de pièces mécaniques nécessaires pour entrainer la roue dentée en rotation.

Cependant, dans un tel dispositif, l'intensité des forces électrostatiques générées par les peignes interdigités est inversement proportionnelle à l'espacement entre les doigts des peignes fixes et les doigts des peignes mobiles.

Or, l'espacement entre les doigts des peignes fixes et les doigts des peignes mobiles dépend de la technique de gravure utilisée pour fabriquer le dispositif.

En effet, pour une profondeur de gravure donnée, l'espacement entre les pièces mécaniques du dispositif doit être supérieur à un espacement minimal prédéfini. Dans le cas contraire, il n'est pas possible de garantir une bonne séparation des pièces

Le document US 5998906 A décrit un microactionneur ayant un peigne fixe et un peigne mobile permettant d'entraîner un miroir, les peignes comprenant des doigts et un mécanisme de verrouillage de sorte que pour une configuration initiale déverrouillée les doigts du peigne mobile ne sont pas engagés entre les doigts du peigne fixe et lorsque le mécanisme est verrouillée, les doigts du peignes mobile et du peigne fixe sont engagés.

### RESUME DE L'INVENTION

Un but de l'invention est de proposer un microsystème électromécanique permettant d'augmenter la puissance motrice générée par les peignes interdigités, en s'affranchissant des contraintes d'espacement imposées par la technique de gravure utilisée.

Ce but est atteint dans le cadre de la présente invention, grâce à un microsystème électromécanique selon la revendication 1.

Il est ainsi possible de concevoir un microsystème électromécanique dans lequel, lors du procédé de fabrication du microsystème électromécanique, les doigts des peignes interdigités ne sont pas engagés entre eux (c'est-à-dire que les doigts du peigne mobile et les doigts du peigne fixe ne s'interpénètrent pas) et peuvent donc être gravés avec un espacement initial supérieur ou égal à l'espacement minimal prédéfini par la technique de gravure.

Cependant, une fois la gravure terminée, le mécanisme de verrouillage peut être verrouillé, afin d'engager les doigts du peigne mobile entre les doigts du peigne fixe (c'est-à-dire que les doigts du peigne mobile et les doigts du peigne fixe s'interpénètrent), de manière à réduire l'espacement entre les doigts des peignes interdigités. L'espacement final obtenu peut être inférieur à l'espacement minimal prédéfini.

Le verrouillage du mécanisme de verrouillages est définitif, en ce sens qu'il permet de maintenir les doigts des peignes avec ce faible espacement, tout au long du fonctionnement ultérieur de l'actionneur.

De cette manière, la puissance motrice générée par les peignes interdigités est supérieure à la puissance motrice qui serait normalement générée avec un actionneur dont les doigts des peignes interdigités présenteraient un espacement supérieur ou égal à l'espacement minimal prédéfini.

Le microsystème électromécanique peut présenter en outre les caractéristiques suivantes :
- lorsque le mécanisme de verrouillage est dans la configuration initiale déverrouillée, les doigts du peigne mobile sont espacés des doigts du peigne fixe avec un premier espacement, et lorsque le mécanisme de verrouillage est dans la configuration finale verrouillée, les doigts du peigne mobile sont espacés des doigts du peigne fixe avec un deuxième espacement, inférieur au premier espacement ;
- le deuxième espacement est compris entre 0,1 et 5 µm, de préférence compris entre 1 et 3 µm ;
- un rapport entre une hauteur des doigts et le deuxième espacement entre les doigts du peigne fixe et les doigts du peigne mobile est compris entre 50 et 400, de préférence compris entre 70 et 150 ;
- l'actionneur comprend une butée qui, une fois que le mécanisme de verrouillage est dans la configuration finale verrouillée, empêche un déplacement de la première partie mobile tendant à désengager les doigts du peigne mobile d'entre les doigts du peigne fixe ;
- le mécanisme de verrouillage comprend au moins un premier ergot d'encliquetage relié à la butée et un deuxième ergot d'encliquetage relié au support, le premier ergot d'encliquetage étant propre à être mis en prise avec le deuxième ergot d'encliquetage lorsque le mécanisme de verrouillage est en configuration finale verrouillée ;
- une fois le premier ergot d'encliquetage mis en prise avec le deuxième ergot d'encliquetage, le premier ergot d'encliquetage et le deuxième ergot d'encliquetage empêchent un retour du mécanisme de verrouillage vers la configuration initiale déverrouillée ;
- le microsystème comprend une suspension reliant la partie mobile d'entrainement au support, et la partie mobile d'entrainement est propre à être déplacée par rapport à la partie fixe d'entrainement dans un premier sens, sous l'effet d'une force électrostatique générée par l'application d'une tension non-nulle entre la partie fixe d'entrainement et la partie mobile d'entrainement, le déplacement de la partie mobile d'entrainement par rapport à la partie fixe d'entrainement provoquant une déformation élastique de la suspension, et la partie mobile d'entrainement est propre à être déplacée par rapport à la partie fixe d'entrainement dans un deuxième sens, opposé au premier sens, lorsque la tension appliquée diminue, sous l'effet d'une force élastique de rappel générée par la suspension ayant été déformée élastiquement, la force élastique de rappel étant opposée à la force électrostatique ;
- le mécanisme de verrouillage comprend un poussoir, le poussoir étant agencé de sorte que lorsque la partie mobile d'entrainement est déplacée pour la première fois par rapport à la partie fixe d'entrainement dans le premier sens, la partie mobile d'entrainement pousse le poussoir dans le premier sens, ce qui a pour effet de faire passer le mécanisme de verrouillage de la configuration initiale déverrouillée à la configuration finale verrouillée ;
- le mécanisme de verrouillage comprend une poutre flexible reliant le poussoir au support, la poutre flexible étant déformée sous l'effet du déplacement du poussoir dans le premier sens.

### PRESENTATION DES DESSINS

D'autres caractéristiques et avantages ressortiront encore de la description qui suit, laquelle est purement illustrative et non limitative, et doit être lue en regard des figures annexées, parmi lesquelles :
- la figure 1 représente de manière schématique, en vue de côté, un microsystème électromécanique conforme à un mode de réalisation possible de l'invention,
- la figure 2 représente de manière schématique, en vue de dessus, le microsystème électromécanique,
- la figure 3 est une vue de détail du microsystème électromécanique de la figure 2, montrant une partie d'un module d'entrainement, une butée et un mécanisme de verrouillage pour positionner la butée,
- la figure 4 est une vue de détail du microsystème électromécanique de la figure 2, montrant une partie d'un module de débrayage,
- la figure 5 est une vue de détail du microsystème électromécanique de la figure 2, montrant une partie d'un module d'indexage,
- la figure 6 est une vue de détail du microsystème électromécanique de la figure 2, montrant une dent d'entrainement et une dent d'indexage,
- la figure 7, la figure 8, la figure 9 et la figure 10 représentent de manière schématique des étapes d'initialisation du mécanisme de verrouillage,
- la figure 11 représente de manière schématique le module d'entrainement, avant l'initialisation du mécanisme de verrouillage,
- la figure 12 représente de manière schématique le module d'entrainement, après l'initialisation du mécanisme de verrouillage,
- la figure 13 est un diagramme représentant de manière schématique les intensités des différentes forces qui agissent sur la dent d'entrainement, lorsque la partie mobile d'entrainement est déplacée par rapport à la partie fixe d'entrainement dans le premier sens, pour une première largeur de poutre flexible,
- la figure 14 est un diagramme représentant de manière schématique l'intensité de la force élastique de rappel qui agit sur la dent d'entrainement, lorsque la partie mobile d'entrainement est déplacée par rapport à la partie fixe d'entrainement dans le deuxième sens, opposé au premier sens, pour une première largeur de poutre flexible,
- la figure 15 est un diagramme représentant de manière schématique les intensités des différentes forces qui agissent sur la dent d'entrainement, lorsque la partie mobile d'entrainement est déplacée par rapport à la partie fixe d'entrainement dans le premier sens, pour une deuxième largeur de poutre flexible,
- la figure 16 est un diagramme représentant de manière schématique l'intensité de la force élastique de rappel qui agit sur la dent d'entrainement, lorsque la partie mobile d'entrainement est déplacée par rapport à la partie fixe d'entrainement dans le deuxième sens, opposé au premier sens, pour une deuxième largeur de poutre flexible,
- la figure 17 est une vue de détail de la forme des doigts des peignes interdigités,
- la figure 18 représente de manière schématique un premier mouvement cyclique de la dent d'entrainement permettant d'entrainer une roue dentée dans un premier sens de rotation,
- la figure 19 représente de manière schématique un deuxième mouvement cyclique de la dent d'entrainement permettant d'entrainer une roue dentée dans un deuxième sens de rotation, opposé au premier sens de rotation,
- la figure 20 et la figure 21 représentent de manière schématique un microsystème électromécanique conforme à un mode de réalisation possible de l'invention, respectivement avant l'initialisation du mécanisme de verrouillage, et après l'initialisation du mécanisme de verrouillage,
- la figure 22 est un diagramme représentant de manière schématique un signal électrique de commande du module d'entrainement, un signal électrique de commande du module d'embrayage, et un signal électrique de commande du module d'indexage, chaque signal électrique de commande ayant une forme en créneau,
- la figure 23 est un diagramme représentant plus en détail le signal électrique de commande du module d'entrainement, le signal électrique de commande du module d'embrayage, et le signal électrique de commande du module d'indexage, sur une période,
- la figure 24 est un diagramme représentant de manière schématique les déplacements du module d'entrainement, du module d'embrayage et du module d'indexage obtenus lorsque l'actionneur est commandé avec les signaux électriques de commande des figures 22 et 23,
- la figure 25 est un diagramme représentant de manière schématique le déplacement du module d'entrainement en fonction de la valeur de la tension du signal électrique de commande du module d'entrainement,
- la figure 26 est un diagramme représentant de manière schématique le déplacement du module d'embrayage en fonction de la valeur de la tension du signal électrique de commande du module d'embrayage,
- la figure 27 est un diagramme représentant de manière schématique le déplacement du module d'indexage en fonction de la valeur de la tension du signal électrique de commande du module d'indexage,
- la figure 28 est un diagramme représentant de manière schématique un signal électrique de commande du module d'entrainement, un signal électrique de commande du module d'embrayage, et un signal électrique de commande du module d'indexage, conformes à un mode de réalisation possible de l'invention,
- la figure 29 est un diagramme représentant de manière schématique le déplacement du module d'entrainement obtenu lorsque l'actionneur est commandé avec les signaux électriques de commande de la figure 14,
- la figure 30 est un diagramme représentant de manière schématique le déplacement du module d'embrayage obtenu lorsque l'actionneur est commandé avec les signaux électriques de commande de la figure 14,
- la figure 31 est un diagramme représentant de manière schématique un signal électrique de commande du module d'entrainement et un signal électrique de commande du module d'embrayage, conformes à un autre mode de réalisation possible de l'invention,
- la figure 32 représente de manière schématique un circuit de commande pour commander le microsystème électromécanique,
- la figure 33 représente de manière schématique un circuit d'amortissement faisant partie du circuit de commande de la figure 32.

### DESCRIPTION DETAILLEE D'UN MODE DE REALISATION

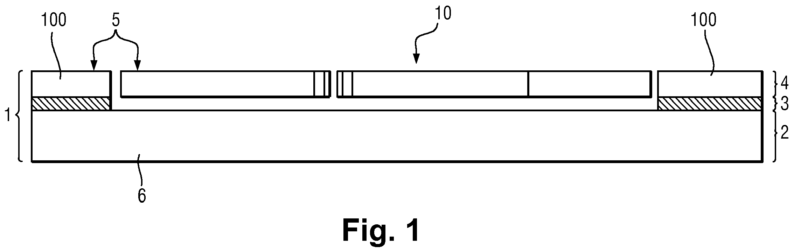

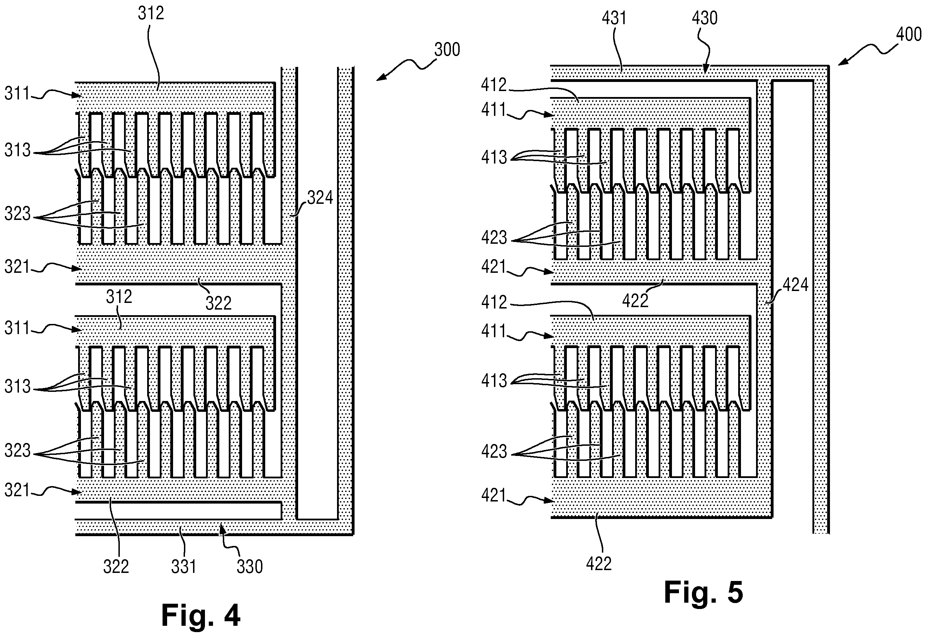

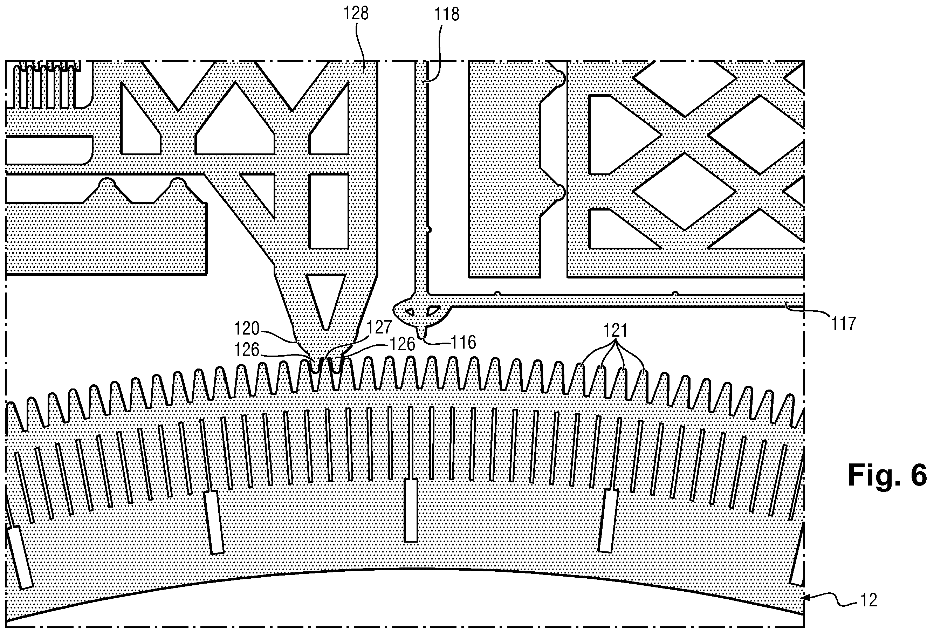

Sur les figures 1 à 6, le microsystème électromécanique 10 représenté a été obtenu par un procédé de gravure dans un substrat 1 en matériau semi-conducteur, tel que du silicium par exemple.

Le substrat 1 utilisé est par exemple du type « Silicon On Insulator » (SOI). Ce substrat 1 comprend une couche inférieure épaisse en silicium (première couche 2), une couche intermédiaire d'oxyde de silicium (deuxième couche 3), et une couche supérieure en silicium (troisième couche 4) d'épaisseur inférieure à celle de la couche inférieure. La couche supérieure 4 du substrat 1 a été gravée pour former un ensemble de pièces mécaniques 5 tandis que la couche inférieure 2 du substrat 1 n'a pas été gravée, de manière à constituer un support 6 pour les pièces mécaniques 5. Une partie de la couche intermédiaire d'oxyde de silicium 3 a servi de couche sacrificielle et a été éliminée pour permettre de détacher les pièces mécaniques mobiles du support 6, tandis qu'une autre partie de la couche sacrificielle subsiste et permet de fixer les pièces mécaniques sur le support 6. De plus, la partie de la couche sacrificielle qui subsiste sert d'isolant électrique entre les pièces mécaniques 5 et le support 6, et par conséquent, entre les différentes pièces mécaniques 5.

Le microsystème électromécanique 10 illustré sur les figures 1 à 6 comprend ainsi un support 6 et des pièces mécaniques 5 présentant des dimensions micrométriques. Les pièces mécaniques 5 sont disposées au-dessus d'une surface du support 6.

Plus précisément, dans l'exemple illustré sur les figures 1 à 6, le microsystème électromécanique 10 comprend un actionneur 11 et une roue 12. L'actionneur 11 a été formé dans la couche supérieure 4 du substrat 1. La roue 12 peut également avoir été formée dans la couche supérieure 4 du substrat 1 ou peut être une pièce rapportée, ayant été formée de manière indépendante.

L'actionneur 11 est configuré pour entrainer la roue 12 en rotation par rapport au support 6, autour d'un axe de rotation.

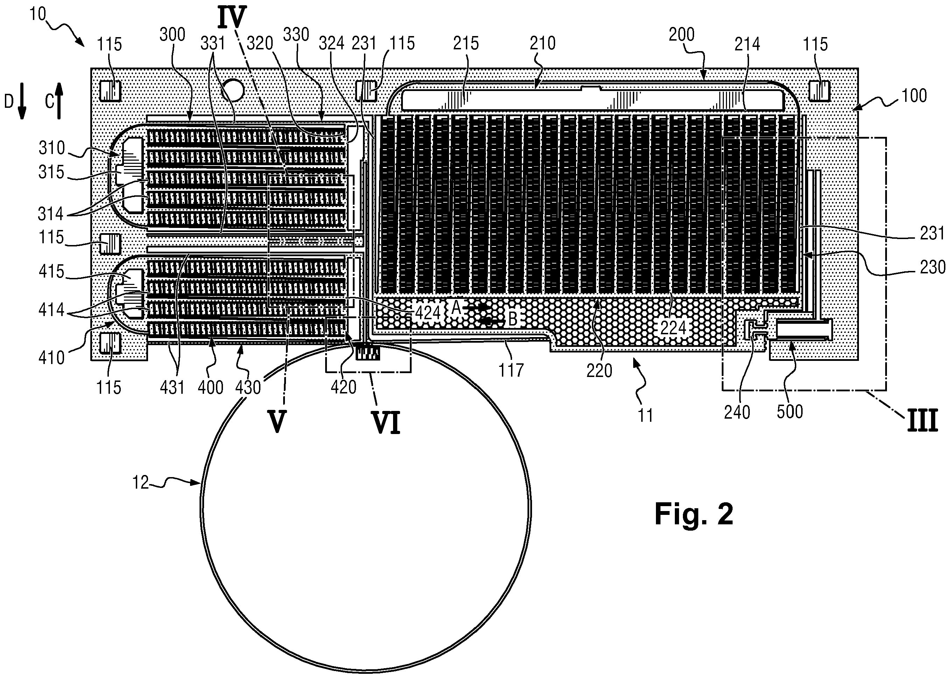

L'actionneur 11 illustré sur les figures 2 à 4 comprend un cadre 100 et trois modules élémentaires 200, 300 et 400.

Le cadre 100 est fixe par rapport au support 6.

Les trois modules élémentaires incluent un module d'entrainement 200, un module d'embrayage 300 et un module d'indexage 400.

La roue 12 est une roue dentée. C'est-à-dire qu'elle présente, à sa périphérie, une série de dents. Chaque dent s'étend selon une direction radiale par rapport à l'axe de rotation de la roue. La roue dentée 12 peut présenter un diamètre compris entre 2000 et 10000 µm. La roue dentée 12 peut par exemple présenter entre 200 et 1000 dents.

Le module d'entrainement 200 comprend une partie fixe d'entrainement 210 et une partie mobile d'entrainement 220.

La partie fixe d'entrainement 210 est montée fixe sur le support 6. La partie fixe d'entrainement 210 comprend un premier portant 214 et une pluralité de peignes fixes 211 s'étendant perpendiculairement à partir du premier portant 214. Chaque peigne fixe 211 comprend une tige 212 et des doigts 213 s'étendant perpendiculairement à partir de la tige 212.

La partie mobile d'entrainement 220 comprend un deuxième portant 224 et une pluralité de peignes mobiles 221 s'étendant perpendiculairement à partir du deuxième portant 224. Chaque peigne mobile 221 comprend une tige 222 et des doigts 223 s'étendant perpendiculairement à partir de la tige 222.

L'actionneur 11 comprend en outre une première suspension 230 reliant la partie mobile d'entrainement 220 au cadre 100. La première suspension 230 comprend deux poutres flexibles 231 s'étendant parallèlement aux tiges 222 des peignes mobiles 221. Les poutres flexibles 231 relient le deuxième portant 224 au cadre 100.

Les peignes mobiles 221 sont agencés en étant intercalés entre les peignes fixes 211. C'est-à-dire que les peignes mobiles 221 sont disposés en alternance avec les peignes fixes 211. De plus, les peignes mobiles 221 et les peignes fixes 211 sont agencés par paires, chaque paire comprenant un peigne fixe 211 et un peigne mobile 221 associé. Plus précisément, les doigts 213 de chaque peigne fixe 211 d'une paire s'étendent avec leurs extrémités libres dirigées vers les doigts 223 du peigne mobile 221 associé de la même paire. De même, les doigts 223 du peigne mobile 221 d'une paire s'étendent avec leurs extrémités libres dirigées vers les doigts 213 du peigne fixe 211 de la même paire. De plus, les doigts 213 des peignes fixes 211 et les doigts 223 des peignes mobiles 221 s'étendent parallèlement à une direction tangentielle.

Par « direction tangentielle », on désigne une direction perpendiculaire à un rayon de la roue 12 passant à l'endroit où l'actionneur 11 interagit avec la roue 12.

Le module d'entrainement 200 comprend en outre un plot de contact 215 formé sur la partie fixe d'entrainement 210. Le plot de contact 215 est propre à être relié à un circuit de commande pour appliquer un signal électrique de commande à la partie fixe d'entrainement 210. Le plot de contact 215 peut être formé par dépôt d'une couche métallique sur la partie fixe d'entrainement 210.

L'actionneur 11 comprend en outre un ou plusieurs plot(s) de contact 115 formé(s) sur le cadre 100. Le ou les plot(s) de contact 115 est(sont) propre(s) à être relié(s) à la terre. Le ou les plot(s) de contact 115 peu(ven)t être formé(s) par dépôt d'une ou plusieurs couche(s) métallique(s) sur le cadre 100.

L'actionneur 11 comprend en outre une dent d'entrainement 116 et une poutre d'entrainement 117 reliant la dent d'entrainement 116 à la partie mobile d'entrainement 220 du module d'entrainement 200.

La dent d'entrainement 116 est propre à engrener avec les dents 121 de la roue dentée 12 pour entrainer la roue dentée 12 en rotation. La poutre d'entrainement 117 s'étend selon une direction tangentielle par rapport à la roue dentée 12.

L'application d'une tension électrique non-nulle entre la partie fixe d'entrainement 210 et la partie mobile d'entrainement 220 via les plots de contact électrique 115, 215, génère une force électrostatique qui attire les peignes mobiles 221 vers les peignes fixes 211. Plus précisément, chaque peigne mobile 221 d'une paire est attiré vers le peigne fixe 211 de la même paire. Sous l'effet de la force électrostatique générée entre les peignes 211, 221, la partie mobile d'entrainement 220 se déplace par rapport à la partie fixe d'entrainement 210 dans un premier sens (flèche A), parallèlement à la direction tangentielle.

Le déplacement de la partie mobile d'entrainement 220 par rapport à la partie fixe d'entrainement 210 dans le premier sens entraine une déformation élastique de la première suspension 230. La déformation élastique de la suspension 230 inclut une flexion des poutres flexibles 231 qui relient la partie mobile d'entrainement 220 au cadre 100. Du fait de cette déformation élastique, la première suspension 230 génère une force élastique de rappel, tendant à s'opposer à la force électrostatique. Cette force élastique de rappel augmente avec l'amplitude de la déformation élastique subie par la première suspension 230.

Lorsque la tension appliquée entre la partie fixe d'entrainement 210 et la partie mobile d'entrainement 220 diminue ou devient nulle, la force électrostatique devient inférieure à la force élastique de rappel ou devient nulle. Sous l'effet de la force élastique de rappel générée par la première suspension 230, la partie mobile d'entrainement 220 se déplace par rapport à la partie fixe d'entrainement 210 dans un deuxième sens (flèche B), opposé au premier sens, parallèlement à la direction tangentielle. Plus précisément, chaque peigne mobile 221 d'une paire s'éloigne du peigne fixe 211 de la même paire.

Comme la dent d'entrainement 116 est reliée par le biais de la poutre d'entrainement 117 à la partie mobile d'entrainement 220, la dent d'entrainement 116 peut ainsi être déplacée, parallèlement à une direction tangentielle, successivement dans le premier sens (flèche A) puis dans le deuxième sens (flèche B) par le module d'entrainement 200.

Le module d'embrayage 300 comprend une partie fixe d'embrayage 310 et une partie mobile d'embrayage 320.

La partie fixe d'embrayage 310 est montée fixe sur le support 6. La partie fixe d'embrayage 310 comprend un troisième portant 314 et une pluralité de peignes fixes 311 s'étendant perpendiculairement à partir du troisième portant 314. Chaque peigne fixe 311 comprend une tige 312 et des doigts 313 s'étendant perpendiculairement à partir de la tige 312.

La partie mobile d'embrayage 320 comprend un quatrième portant 324 et une pluralité de peignes mobiles 321 s'étendant perpendiculairement à partir du quatrième portant 324. Chaque peigne mobile 321 comprend une tige 322 et des doigts 323 s'étendant perpendiculairement à partir de la tige 322.

Les peignes fixes 311 et les peignes mobiles 321 du module d'embrayage 300 sont orientés perpendiculairement par rapport aux peignes fixes 211 et aux peignes mobiles 221 du module d'entrainement 200.

L'actionneur 11 comprend en outre une deuxième suspension 330 reliant la partie mobile d'embrayage 320 au cadre 100. La deuxième suspension 330 comprend deux poutres flexibles 331 s'étendant parallèlement aux tiges 322 des peignes mobiles 321. Les poutres flexibles 331 relient le quatrième portant 324 au cadre 100.

Les peignes mobiles 321 sont agencés en étant intercalés entre les peignes fixes 311. De plus, les peignes mobiles 321 et les peignes fixes 311 sont agencés par paires, chaque paire comprenant un peigne fixe 311 et un peigne mobile 321 associé. Plus précisément, les doigts 313 de chaque peigne fixe 311 d'une paire s'étendent avec leurs extrémités libres dirigées vers les doigts 323 du peigne mobile 321 associé. De même, les doigts 323 du peigne mobile 321 s'étendent avec leurs extrémités libres dirigées vers les doigts 313 du peigne fixe 311. De plus, les doigts 313 des peignes fixes 311 et les doigts 323 des peignes mobiles 321 s'étendent parallèlement à une direction radiale.

Par « direction radiale », on désigne une direction parallèle au rayon de la roue 12 passant à l'endroit où l'actionneur 11 interagit avec la roue 12.

Le module d'embrayage 300 comprend en outre un plot de contact 315 formé sur la partie fixe d'embrayage 310. Le plot de contact 315 est propre à être relié à une source de potentiel électrique pour appliquer un signal électrique de commande à la partie fixe d'embrayage 310.

L'actionneur 11 comprend en outre une poutre d'embrayage 118 reliant la dent d'entrainement 116 à la partie mobile d'embrayage 320 du module d'embrayage 300.

La poutre d'embrayage 118 s'étend selon une direction radiale par rapport à la roue dentée 12.

L'application d'une tension non-nulle entre la partie fixe d'embrayage 310 et la partie mobile d'embrayage 320 via les plots de contact électrique 115, 315, génère une force électrostatique qui attire les peignes mobiles 321 vers les peignes fixes 311. Plus précisément, chaque peigne mobile 321 d'une paire est attiré vers le peigne fixe 311 de la même paire. Sous l'effet de la force électrostatique générée, la partie mobile d'embrayage 320 se déplace par rapport à la partie fixe d'embrayage 310 dans un troisième sens (flèche C), parallèlement à la direction radiale.

Le déplacement de la partie mobile d'embrayage 320 par rapport à la partie fixe d'embrayage 310 dans le troisième sens entraine une déformation élastique de la deuxième suspension 330. La déformation élastique de la suspension 330 inclut une flexion des poutres flexibles 331 qui relient la partie mobile d'embrayage 320 au cadre 100. Du fait de cette déformation élastique, la deuxième suspension 330 génère une force élastique de rappel, tendant à s'opposer à la force électrostatique. Cette force élastique de rappel augmente avec l'amplitude de la déformation élastique.

Lorsque la tension appliquée entre la partie fixe d'embrayage 310 et la partie mobile d'embrayage 320 diminue ou devient nulle, la force électrostatique devient inférieure à la force élastique de rappel ou devient nulle. Sous l'effet de la force élastique de rappel générée par la deuxième suspension 330, la partie mobile d'embrayage 320 se déplace par rapport à la partie fixe d'embrayage 310 dans un quatrième sens (flèche D), opposé au troisième sens, parallèlement à la direction radiale.

Comme la dent d'entrainement 116 est reliée par le biais de la poutre d'embrayage 118 à la partie mobile d'embrayage 320, la dent d'entrainement 116 peut ainsi être déplacée, parallèlement à une direction radiale, successivement dans le troisième sens (flèche C) et dans le quatrième sens (flèche D) par le module d'embrayage 300.

La poutre d'entrainement 117 et la poutre d'embrayage 118 sont chacune suffisamment flexibles pour transmettre respectivement le mouvement tangentiel généré par le module d'entrainement 200 et le mouvement radial généré par le module d'embrayage 300 à la dent d'entrainement 116, tout en permettant un découplage des deux mouvements. De cette manière, les deux mouvements (mouvement tangentiel et mouvement radial) peuvent être commandés indépendamment l'un de l'autre.

Le module d'indexage 400 comprend une partie fixe d'indexage 410 et une partie mobile d'indexage 420.

La partie fixe d'indexage 410 est montée fixe sur le support. La partie fixe d'indexage 410 comprend un cinquième portant 414 et une pluralité de peignes fixes 411 s'étendant perpendiculairement à partir du cinquième portant 414. Chaque peigne fixe 411 comprend une tige 412 et des doigts 413 s'étendant perpendiculairement à partir de la tige 412.

La partie mobile d'indexage 420 comprend un sixième portant 424 et une pluralité de peignes mobiles 421 s'étendant perpendiculairement à partir du sixième portant 424. Chaque peigne mobile 421 comprend une tige 422 et des doigts 423 s'étendant perpendiculairement à partir de la tige 422.

L'actionneur 11 comprend en outre une troisième suspension 430 reliant la partie mobile d'indexage 420 au cadre 100. La troisième suspension 430 comprend deux poutres flexibles 431 s'étendant parallèlement aux tiges 422 des peignes 421. Les poutres flexibles 431 relient la poutre transversale 424 au cadre 100.

Les peignes mobiles 421 sont agencés en étant intercalés entre les peignes fixes 411. De plus, les peignes mobiles 421 et les peignes fixes 411 sont agencés par paires, chaque paire comprenant un peigne fixe 411 et un peigne mobile 421 associé. Plus précisément, les doigts 413 de chaque peigne fixe 411 d'une paire s'étendent avec leurs extrémités libres dirigées vers les doigts 423 du peigne mobile 421 associé. De même, les doigts 423 du peigne mobile 421 s'étendent avec leurs extrémités libres dirigées vers les doigts 413 du peigne fixe 411. De plus, les doigts 413 des peignes fixes 411 et les doigts 423 des peignes mobiles 421 s'étendent parallèlement à une direction radiale.

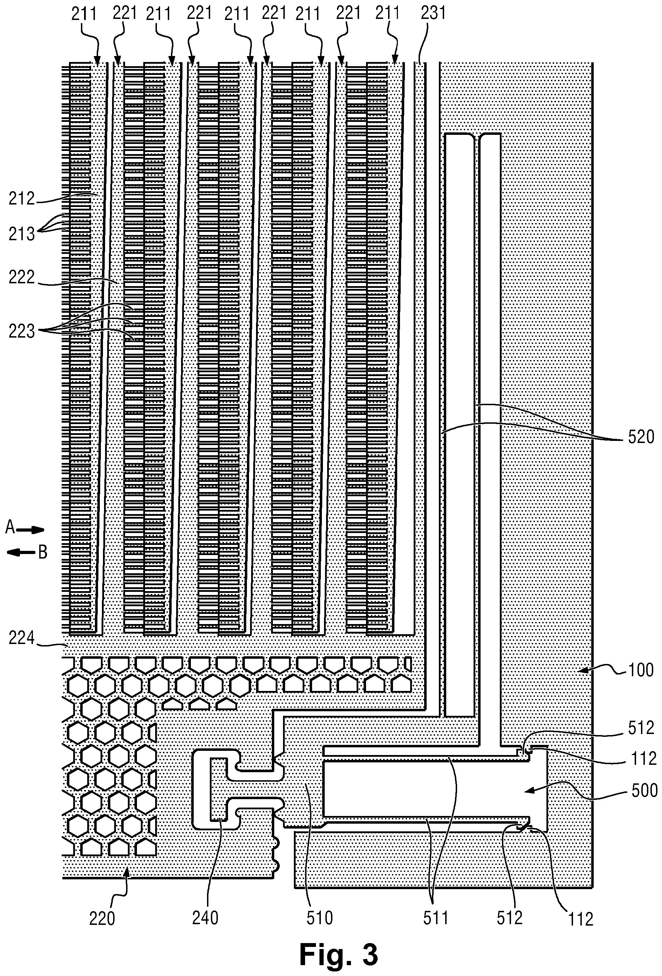

L'actionneur 11 comprend en outre une dent d'indexage 120. Dans l'exemple illustré sur la figure 3, la dent d'indexage 120 comprend deux protubérances 126 et un renfoncement 127 ménagé entre les deux protubérances 126. Lorsque la dent d'indexage 120 est engagée avec les dents 121 de la roue dentée 12, le renfoncement 127 reçoit une dent 121 de la roue dentée 12 dans le renfoncement 127, ce qui a pour effet de bloquer la roue 12 en rotation.

L'actionneur 11 comprend en outre une poutre d'indexage 128 reliant la dent d'indexage 120 à la partie mobile d'indexage 420 du module d'indexage 400.

La poutre d'indexage 128 s'étend selon une direction radiale par rapport à la roue dentée 12.

L'application d'une tension non-nulle entre la partie fixe d'indexage 410 et la partie mobile d'indexage 420 via les plots de contact électrique 415 et 115, génère une force électrostatique qui attire les peignes mobiles 421 vers les peignes fixes 411. Plus précisément, chaque peigne mobile 421 d'une paire est attiré vers le peigne fixe 411 de la même paire. Sous l'effet de la force électrostatique générée, la partie mobile d'indexage 420 se déplace par rapport à la partie fixe d'indexage 410 dans le troisième sens (flèche C), parallèlement à la direction radiale.

Le déplacement de la partie mobile d'indexage 420 par rapport à la partie fixe d'indexage 410 dans le troisième sens entraine une déformation élastique de la troisième suspension 430. La déformation élastique de la suspension 430 inclut une flexion des poutres flexibles 431 qui relient la partie mobile d'indexage 420 au cadre 100. Du fait de cette déformation élastique, la troisième suspension 430 génère une force élastique de rappel, tendant à s'opposer à la force électrostatique. Cette force élastique de rappel augmente avec l'amplitude de la déformation élastique.

Lorsque la tension appliquée entre la partie fixe d'indexage 410 et la partie mobile d'indexage 420 diminue ou devient nulle, la force électrostatique devient inférieure à la force élastique de rappel ou devient nulle. Sous l'effet de la force élastique de rappel générée par la troisième suspension, la partie mobile d'indexage 420 se déplace en s'éloignant de la partie fixe d'indexage 410 dans le quatrième sens (flèche D), opposé au troisième sens, parallèlement à la direction radiale.

Comme la dent d'indexage 120 est reliée par le biais de la poutre d'indexage 128 à la partie mobile d'indexage 420, la dent d'indexage 120 est ainsi déplacée, parallèlement à une direction radiale, successivement dans le troisième sens et dans le quatrième sens par le module d'indexage.

Il est ainsi possible de déplacer la dent d'indexage 120 selon un mouvement radial alternatif, par rapport à la roue 12.

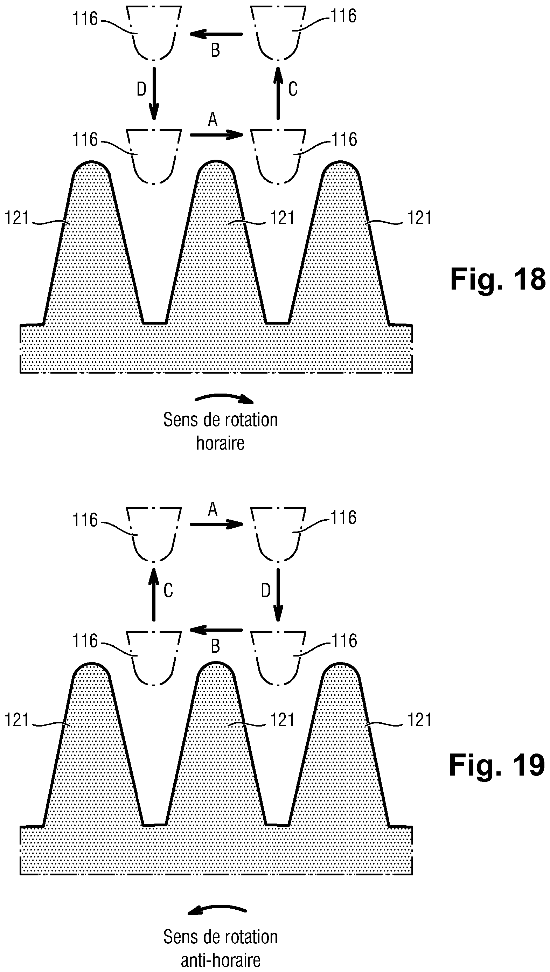

En commandant de manière appropriée le module d'entrainement 200 et le module d'embrayage 300 au moyen de signaux électriques de commande périodiques déphasés, il est possible de déplacer la dent d'entrainement 116 selon un premier mouvement cyclique en hystérésis (mouvement illustré sur la figure 18) ou selon un deuxième mouvement cyclique en hystérésis (mouvement illustré sur la figure 19), inversé par rapport au premier mouvement cyclique en hystérésis.

Lorsque la dent d'entrainement 116 est déplacée selon le premier mouvement cyclique en hystérésis, la dent d'entrainement 116 engrène avec des dents successives 121 de la roue dentée 12, de manière à entrainer la roue dentée 12 dans un mouvement de rotation pas à pas, selon un premier sens de rotation.

Lorsque la dent est déplacée selon le deuxième mouvement cyclique en hystérésis, la dent d'entrainement 116 engrène avec des dents successives 121 de la roue dentée 12, de manière à entrainer la roue dentée 12 dans un mouvement de rotation pas à pas, selon un deuxième sens de rotation, opposé au premier sens de rotation.

En parallèle, le module d'indexage 400 est commandé au moyen d'un signal électrique de commande, en opposition de phase avec le signal électrique de commande appliqué au module d'embrayage 300.

De cette manière, la dent d'indexage 120 est engagée avec les dents 121 de la roue 12 lorsque la dent d'entrainement 116 est désengagée d'avec les dents 121 de la roue 12. A l'inverse, la dent d'indexage 120 est désengagée d'avec les dents 121 de la roue 12 lorsque la dent d'entrainement 116 est engagée avec les dents 121 de la roue 12.

La dent d'indexage 120 empêche ainsi une rotation intempestive de la roue 12, pendant que la dent d'entrainement 116 est désengagée d'avec les dents 121 de la roue 12 (pendant les phases de débrayage). En revanche, la dent d'indexage 120 ne fait pas obstacle à la rotation de la roue 121 provoquée par la dent d'entrainement 116 (pendant les phases d'entrainement).

L'actionneur 11 comprend en outre une butée 240 permettant de limiter un déplacement de la partie mobile d'entrainement 220 du module d'entrainement 200 dans le deuxième sens (flèche B).

L'actionneur 11 comprend également un mécanisme de verrouillage 500 pour positionner la butée 240 par rapport au support dans une position prédéfinie.

Sur la figure 3, la butée 240 et le mécanisme de verrouillage 500 sont représentés tels qu'ils sont obtenus immédiatement après la fabrication du microsystème électromécanique 10, c'est-à-dire avant le verrouillage du mécanisme de verrouillage 500 qui précède la mise en fonctionnement du microsystème électromécanique.

Sur cette figure, le mécanisme de verrouillage 500 est en configuration déverrouillée.

De plus, comme cela est visible sur cette figure, dans cette configuration, les doigts 223 des peignes mobiles 221 du module d'entrainement 200 ne sont pas engagés entre les doigts 213 des peignes fixes 211 du module d'entrainement 200.

Le mécanisme de verrouillage 500 comprend un poussoir 510 et des pattes élastiques 511 s'étendant à partir du poussoir 510 selon une direction tangentielle. Dans l'exemple illustré sur la figure 3, le mécanisme de verrouillage comprend deux pattes élastiques 511.

Chaque patte élastique 511 présente une extrémité libre et comprend un premier ergot d'encliquetage 512 agencé à son extrémité libre.

Le mécanisme de verrouillage 500 comprend en outre des poutres flexibles 520 reliant le poussoir 510 au cadre 100. Dans l'exemple illustré sur la figure 2, le mécanisme de verrouillage 500 comprend deux poutres flexibles 520. Les poutres flexibles 520 parallèles entre elles, s'étendent selon une direction radiale.

La butée 240 est solidaire du poussoir 510. Autrement dit, la butée 240 est fixe par rapport au poussoir 510. Plus précisément, dans l'exemple illustré sur la figure 3, la butée 240 et le poussoir 510 sont formés en une seule pièce unique de matériau.

Par ailleurs, le cadre 100 comprend des deuxièmes ergots d'encliquetage 112. Dans l'exemple illustré sur la figure 3, le cadre 100 comprend deux deuxièmes ergots d'encliquetage 112.

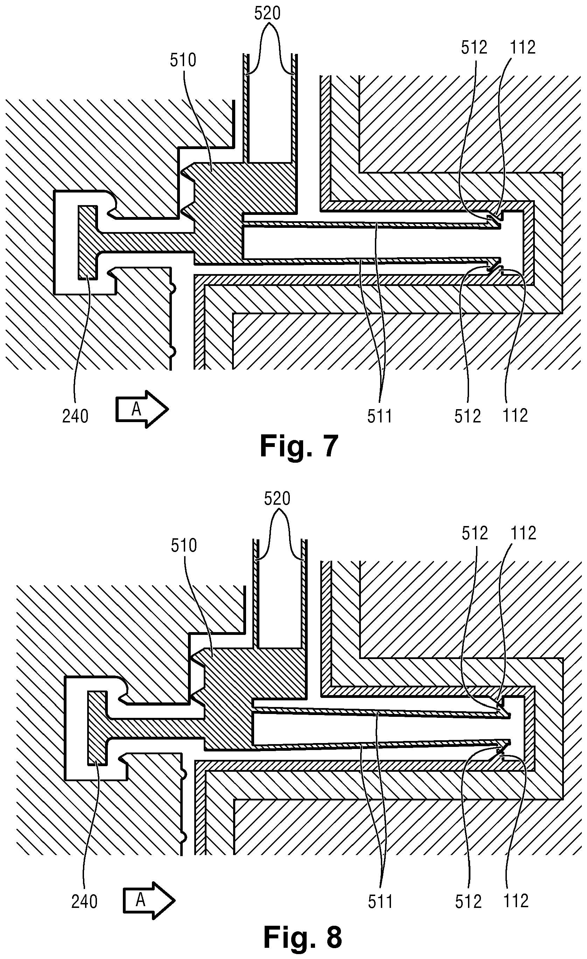

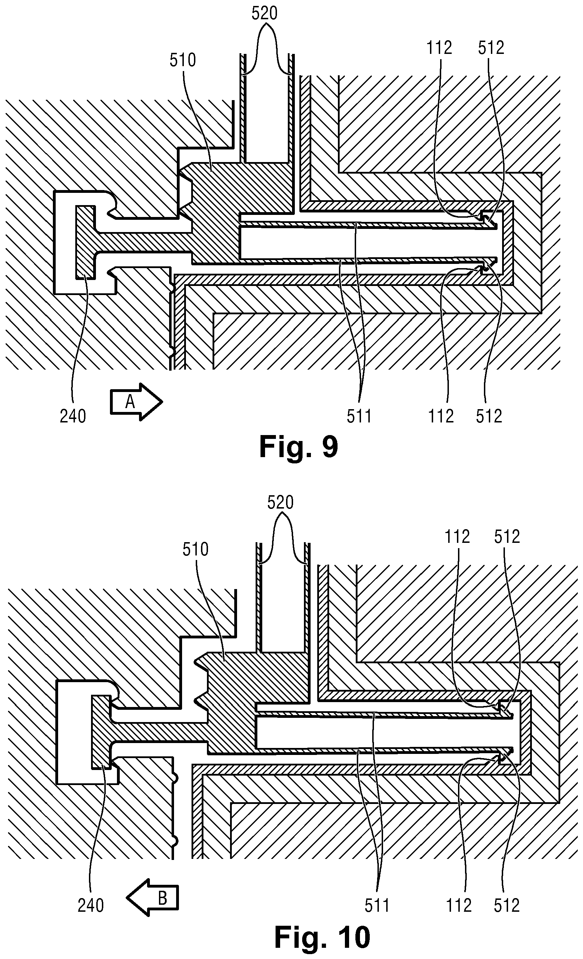

Les figures 7 à 10 représentent de manière schématique des étapes de verrouillage du mécanisme de verrouillage 500, permettant de faire passer le mécanisme de verrouillage 500 de la configuration déverrouillée (configuration illustrée sur la figure 7) à une configuration verrouillée (configuration illustrée sur la figure 10).

Comme illustré sur la figure 7, une tension électrique non-nulle est appliquée entre la partie fixe d'entrainement 210 et la partie mobile d'entrainement 220 du module d'entrainement 200 via les plots de contact électrique 115, 215.

La tension électrique appliquée génère une force électrostatique qui a pour effet de déplacer la partie mobile d'entrainement 220 du module d'entrainement 200 par rapport à la partie fixe d'entrainement 210 dans le premier sens (flèche A), parallèlement à la direction tangentielle.

Comme illustré sur la figure 8, au cours de son déplacement, la partie mobile d'entrainement 220 pousse le poussoir 510, ce qui a pour effet de déplacer le poussoir 510 et de déplacer également la butée 240 dans le premier sens (flèche A).

Cela a également pour effet de pousser les premiers ergots d'encliquetage 512 contre les deuxièmes ergots d'encliquetage 112.

Du fait de leurs formes, les premiers ergots d'encliquetage 512 glissent sur les deuxièmes ergots d'encliquetage 112 en provoquant une flexion des pattes élastiques 511. Dans l'exemple illustré sur la figure 8, les pattes élastiques 511 fléchissent en se rapprochant l'une de l'autre.

Comme illustré sur la figure 9, grâce à la flexion des pattes élastiques 511, les premiers ergots d'encliquetage 512 sont poussés au-delà des deuxièmes ergots d'encliquetage 112.

Une fois que les premiers ergots d'encliquetage 512 ont dépassé les deuxièmes ergots d'encliquetage 112, les pattes élastiques 511 tendent à reprendre leur forme initiale. Dans l'exemple illustré sur la figure 9, les pattes élastiques 511 s'écartent l'une de l'autre. L'écartement des pattes élastiques 511 a pour effet de mettre en prise les premiers ergots d'encliquetage 512 avec les deuxièmes ergots d'encliquetage 112.

Comme illustré sur la figure 10, la tension électrique appliquée entre la partie fixe d'entrainement 210 et la partie mobile d'entrainement 220 du module d'entrainement 200 est ensuite supprimée. La force électrostatique disparait.

Sous l'effet de la force élastique de rappel exercée par la première suspension 230, la partie mobile d'entrainement 220 du module d'entrainement 200 est déplacée par rapport à la partie fixe d'entrainement 210 du module d'entrainement 200 dans le deuxième sens (flèche B), parallèlement à la direction tangentielle. La partie mobile d'entrainement 220 du module d'entrainement 200 est déplacée par rapport à la partie fixe d'entrainement 210 dans le deuxième sens jusqu'à ce que la partie mobile d'entrainement 220 du module d'entrainement 200 vienne en appui contre la butée 240.

Cependant, la butée 240 est retenue par les premiers ergots d'encliquetage 512 et les deuxièmes ergots d'encliquetage 112, qui empêchent un retour du poussoir 510 dans sa position initiale.

Une fois que le mécanisme de verrouillage 500 est en configuration verrouillée, la butée 240 se trouve dans une position dans laquelle la butée 240 empêche un déplacement de la première partie mobile d'entrainement 220 dans le deuxième sens jusqu'à une position de repos dans laquelle la force élastique générée par la première suspension serait nulle.

Autrement dit, la butée 240 est positionnée de manière à maintenir la première suspension 230 dans un état de déformation élastique permanent. La position de la butée 240 détermine une valeur minimale de la force élastique de rappel exercée par la première suspension 230.

Du fait de la présence de la butée 240, la force élastique de rappel exercée par la première suspension 230 ne peut être inférieure à cette valeur minimale.

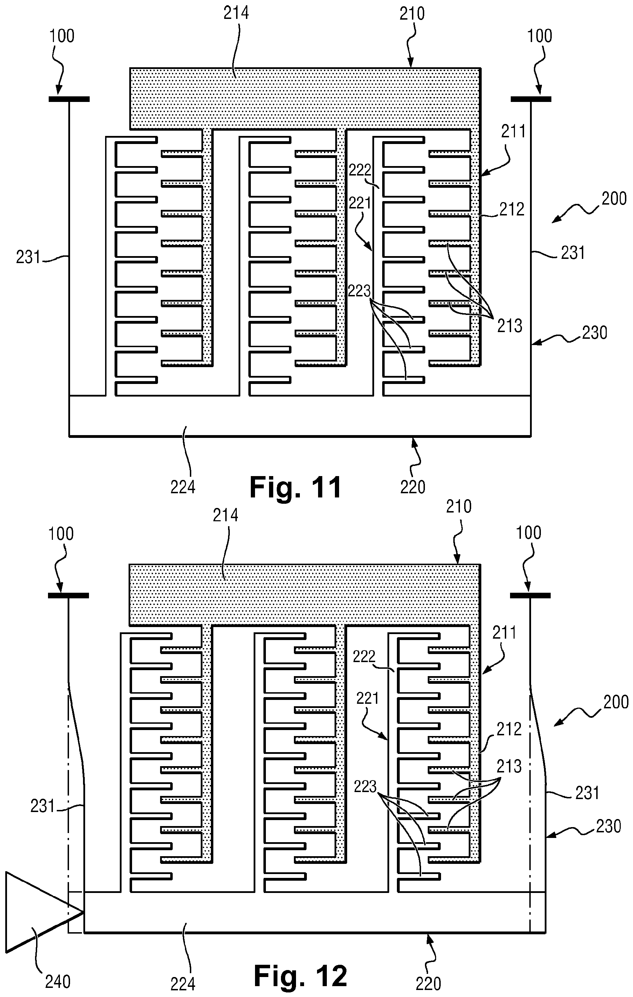

La figure 11 représente de manière schématique le module d'entrainement 200, avant le verrouillage du mécanisme de verrouillage 500.

Comme illustré sur cette figure, les doigts 223 des peignes mobiles 221 ne sont pas engagés entre les doigts 213 des peignes fixes 211.

De plus, la première suspension 230 se trouve dans une position de repos. C'est-à-dire que les poutres flexibles 231 de la première suspension 230 ne sont pas déformées. La force élastique de rappel exercée par la première suspension 230 est donc nulle.

La figure 12 représente de manière schématique le module d'entrainement 200, après le verrouillage du mécanisme de verrouillage 500.

Comme illustré sur cette figure, les doigts 223 des peignes mobiles 221 sont partiellement engagés dans les espaces ménagés entre les doigts 213 des peignes fixes 211.

Comme la butée 240 empêche un retour de la partie mobile d'entrainement 220 jusqu'à la position de repos, les poutres flexibles 231 sont maintenues dans un état de déformation élastique. De cette manière, la force élastique de rappel exercée par la première suspension 230 n'est pas nulle.

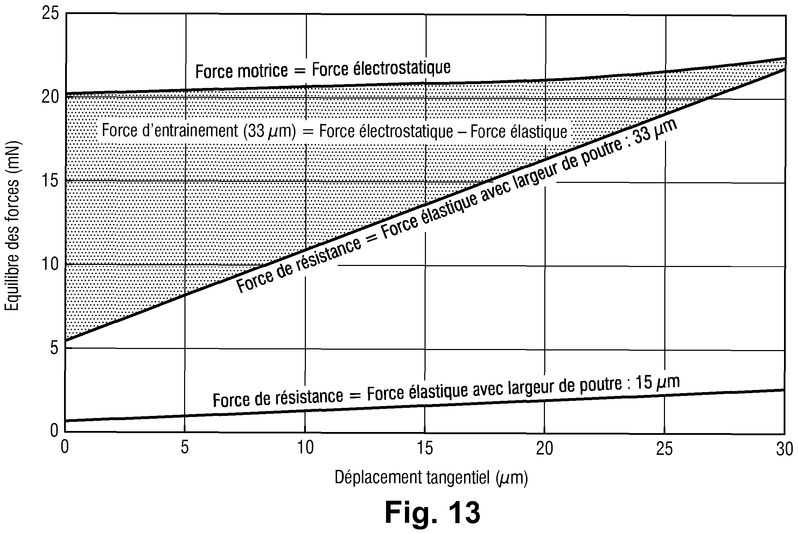

La figure 13 est un diagramme représentant de manière schématique les intensités des différentes forces qui agissent sur la dent d'entrainement 116, lorsque la partie mobile d'entrainement 220 est déplacée par rapport à la partie fixe d'entrainement 210 dans le premier sens (sens de la flèche A).

Les forces qui agissent sur la dent d'entrainement 116 sont la force électrostatique générée par la tension électrique appliquée entre la partie fixe d'entrainement 210 et la partie mobile d'entrainement 220, et la force élastique de rappel due à la déformation de la première suspension 230.

La force élastique de rappel s'oppose à la force électrostatique. Ainsi, l'intensité de la force d'entrainement exercée sur la dent d'entrainement 116 est la différence entre l'intensité de la force électrostatique et l'intensité de la force élastique de rappel.

La zone grisée du diagramme de la figure 13 illustre la force d'entraînement exercée sur la dent d'entraînement 116 pour une première valeur de raideur de la première suspension 230 (largeur de poutre : 33µm) selon le premier sens de rotation (sens de la flèche A).

Comme cela est visible sur ce diagramme, l'intensité de la force électrostatique reste relativement constante au cours du déplacement de la partie mobile d'entrainement 220 par rapport à la partie fixe d'entrainement 210.

En revanche, l'intensité de la force élastique de rappel augmente à mesure que la partie mobile d'entrainement 220 est déplacée dans le premier sens.

L'augmentation de l'intensité de la force élastique de rappel dépend de la raideur de la première suspension 230. A titre de comparaison, le diagramme montre une variation de l'intensité de la force élastique de rappel pour une première valeur de raideur de la première suspension 230 (largeur de poutre = 33 µm) et une variation de l'intensité de la force élastique de rappel pour une deuxième valeur de raideur de la première suspension 230 (largeur de poutre = 15 µm).

De plus, lorsque le déplacement de la partie mobile d'entrainement 220 est nul, l'intensité de la force élastique de rappel n'est pas nulle. En effet, dans cette position, la première suspension 230 est déformée du fait de la présence de la butée 240.

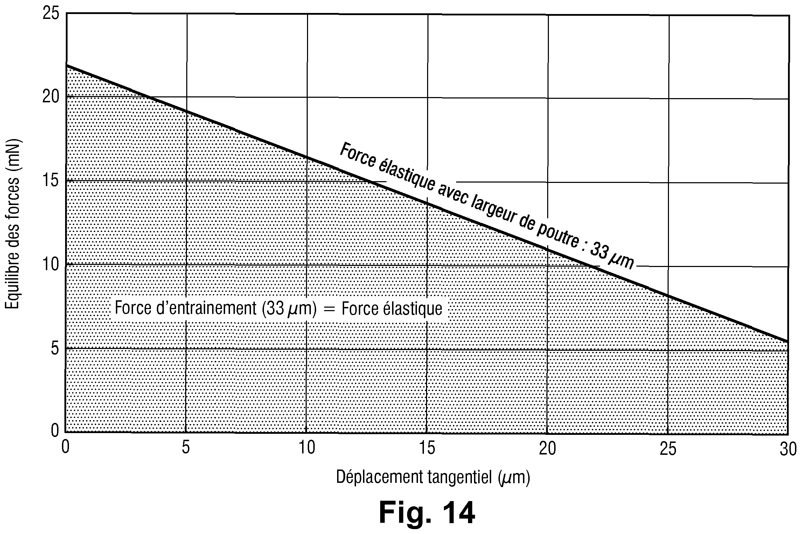

La figure 14 est un diagramme représentant de manière schématique l'intensité de la force élastique de rappel qui agit sur la dent d'entrainement 116, lorsque la partie mobile d'entrainement 220 est déplacée par rapport à la partie fixe d'entrainement 210 dans le deuxième sens (sens de la flèche B), opposé au premier sens.

Comme cela est visible sur ce diagramme, aucune force électrostatique n'agit sur la partie mobile.

La partie mobile d'entrainement 220 est déplacée par rapport à la partie fixe d'entrainement 210, dans le deuxième sens, uniquement sous l'action de la force élastique de rappel.

L'intensité de la force élastique de rappel diminue à mesure que la partie mobile d'entrainement 220 est déplacée dans le deuxième sens. Toutefois, grâce à la présence de la butée 240, l'intensité de la force élastique de rappel ne devient pas nulle. L'intensité de la force élastique de rappel reste supérieure à une valeur minimale, non-nulle.

Comme illustré sur ce diagramme, la diminution de l'intensité de la force élastique de rappel dépend de la raideur de la première suspension 230. Ainsi, le diagramme montre une variation de l'intensité de la force élastique de rappel pour la première valeur de raideur de la première suspension (largeur de poutre = 33 µm).

La zone grisée du diagramme la figure 14 illustre la force d'entraînement exercée sur la dent d'entraînement 116 pour une première valeur de raideur de la première suspension 230 (largeur de poutre : 33µm) selon le deuxième sens de rotation (sens de la flèche B).

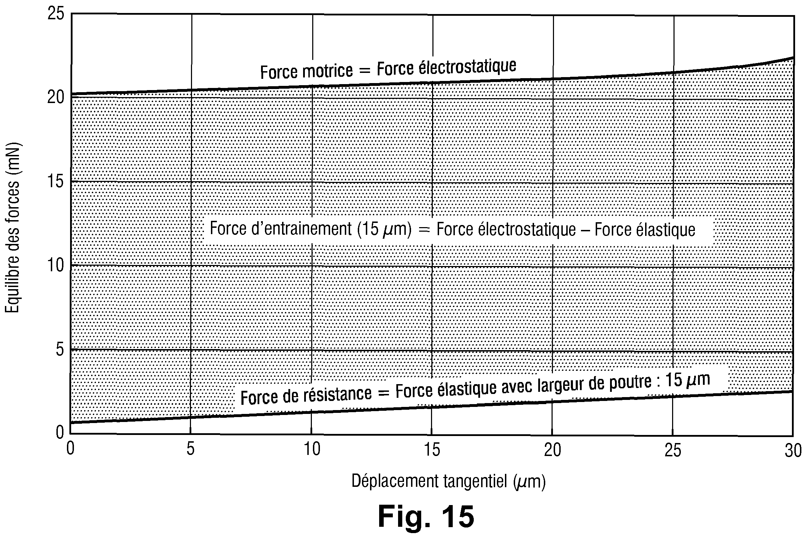

La figure 15 est un diagramme représentant de manière schématique les intensités des différentes forces qui agissent sur la dent d'entrainement 116, lorsque la partie mobile d'entrainement 220 est déplacée par rapport à la partie fixe d'entrainement 210 dans le premier sens.

Les forces qui agissent sur la dent d'entrainement 116 sont la force électrostatique générée par la tension appliquée entre la partie fixe d'entrainement 210 et la partie mobile d'entrainement 220, et la force élastique de rappel due à la déformation de la première suspension 230. La force élastique de rappel s'oppose à la force électrostatique.

Le diagramme montre une variation de l'intensité de la force élastique de rappel pour la deuxième valeur de raideur de la première suspension 230 (largeur de poutre = 15 µm).

La zone grisée du diagramme de la figure 15 montre la variation de l'intensité de la force d'entraînement exercée sur la dent d'entraînement 116 selon le premier sens (sens de la flèche A) pour la deuxième valeur de raideur de la première suspension 230 (largeur de poutre : 15 µm). Cette deuxième valeur de raideur, plus faible que la première valeur de raideur, conduit à une zone grisée plus importante (comparaison des aires des zones grisées des figures 13 et 15) et donc à une intensité de la force d'entraînement selon le premier sens plus importante également.

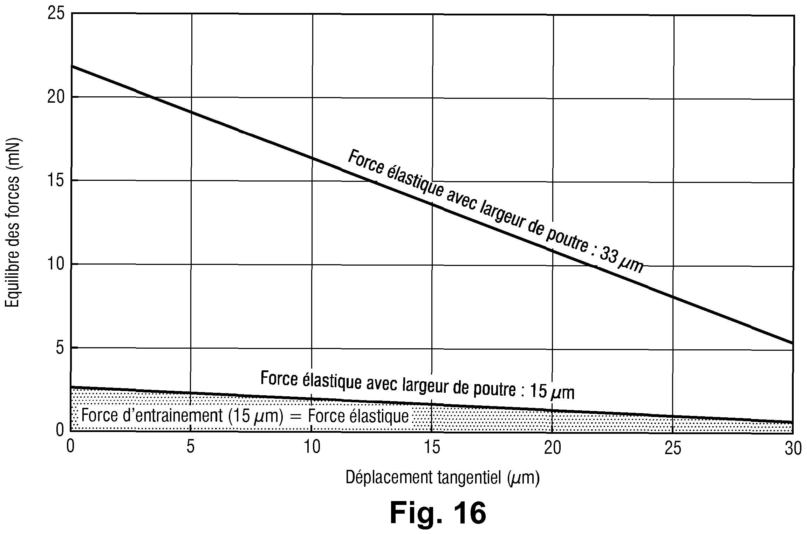

La figure 16 est un diagramme représentant de manière schématique l'intensité de la force élastique de rappel qui agit sur la dent d'entrainement 116, lorsque la partie mobile d'entrainement 220 est déplacée par rapport à la partie fixe d'entrainement 210 dans le deuxième sens, opposé au premier sens, pour la deuxième valeur de raideur de la première suspension 230.

Comme cela est visible sur ce diagramme, aucune force électrostatique n'agit sur la partie mobile d'entrainement 220.

La partie mobile d'entrainement 220 est déplacée par rapport à la partie fixe d'entrainement 210, dans le deuxième sens, uniquement sous l'action de la force élastique de rappel.

L'intensité de la force élastique de rappel diminue à mesure que la partie mobile d'entrainement 220 est déplacée dans le deuxième sens.

Toutefois, grâce à la présence de la butée 240, l'intensité de la force élastique de rappel ne devient pas nulle. L'intensité de la force élastique de rappel reste supérieure à une valeur minimale, non-nulle.

Le diagramme montre une variation de l'intensité de la force élastique de rappel pour la deuxième valeur de raideur de la première suspension 240 (largeur de poutre = 15 µm).

La zone grisée du diagramme de la figure 16 illustre la force d'entraînement exercée sur la dent d'entraînement 116 pour la deuxième valeur de raideur de la première suspension 230 (largeur de poutre : 15 µm) selon le deuxième sens de rotation (sens de la flèche B). A titre de comparaison, la force d'entraînement selon le deuxième sens pour la première valeur de raideur est également reportée sur ce même diagramme.

Les figures 13 à 16 montrent que plus la raideur de la première suspension 230 est élevée, plus la force d'entrainement servant à entrainer la roue dentée 12 dans le premier sens de rotation diminue rapidement.

Ainsi, en fonction des applications visées, la raideur de la première suspension 230 peut être ajustée afin de privilégier une meilleure efficacité de l'entrainement en rotation de la roue dentée 12 dans le premier sens de rotation ou une meilleure efficacité de l'entrainement en rotation de la roue dentée 12 dans le deuxième sens de rotation.

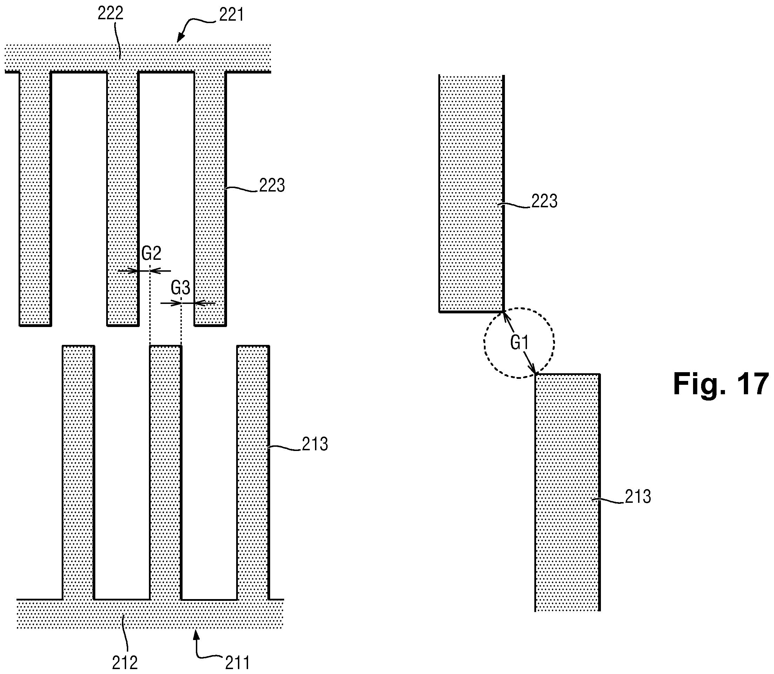

La figure 17 est une vue de détail de la forme des doigts 213 d'un peigne fixe 211 et de celle des doigts 223 d'un peigne mobile 221 du module d'entrainement 200.

Les techniques de gravure utilisées pour la gravure de microsystèmes électromécaniques en série nécessitent de ménager un espacement minimal entre les parties fixes et les parties mobiles de chaque microsystème.

Par exemple, dans le cas d'un microsystème électromécanique, tel que celui qui est illustré sur les figures 1 à 6, il est nécessaire de ménager un espacement minimal entre les doigts des peignes fixes et mobiles.

L'espacement minimal Gu dépend de la profondeur de gravure. Par exemple, pour une gravure réalisée par une technique de gravure ionique réactive profonde (DRIE) à une profondeur de 200 µm, l'espacement Gu minimal peut être d'environ 4 à 6 µm.

Avant le verrouillage du mécanisme de verrouillage 500, les doigts 223 du peigne mobile 221 ne sont pas engagés entre les doigts 213 du peigne fixe 211. Les doigts 223 du peigne mobile 221 sont espacés des doigts 213 du peigne fixe 211 les plus proches avec un premier espacement G1.

L'espacement G1 entre les doigts 213 du peigne fixe 211 et les doigts 223 du peigne mobile 221 est supérieur à l'espacement minimal Gu. L'« espacement » entre deux doigts est défini comme étant la plus courte distance séparant les deux doigts.

Après le verrouillage du mécanisme de verrouillage 500, les doigts 223 du peigne mobile 221 sont engagés entre les doigts 213 du peigne fixe 211.

De cette manière, les doigts 223 du peigne mobile 221 sont espacés des doigts 213 du peigne fixe 211 les plus proches avec un deuxième espacement G2 et avec un troisième espacement G3, inférieurs au premier espacement G1. Plus précisément, le doigt 223 du peigne mobile 221 est espacé d'un doigt 213 du peigne fixe 211 situé d'un côté du doigt 223 du peigne mobile 221 avec le deuxième espacement G2, et est espacé d'un autre doigt 213 du peigne fixe 211 situé de l'autre côté du doigt 223 du peigne mobile 221 avec le troisième espacement G3. Les espacements G2 et G3 entre les doigts 213 et 223 des peignes fixes 211 et les doigts 223 des peignes mobiles 221 peuvent être inférieurs à l'espacement minimal Gu. L'espacement G2 et/ou l'espacement G3 peut être compris entre 0,1 et 5 µm, de préférence compris entre 1 et 3 µm. Par exemple, l'espacement G2 peut être égal 3 µm et l'espacement G3 peut être égal à 4 µm.

En particulier, le rapport entre l'épaisseur des doigts 213, 223 (c'est-à-dire la profondeur de gravure de la couche supérieure en silicium) et l'espacement entre les doigts 213 du peigne fixe 211 et les doigts 223 du peigne mobile 221peut être compris entre 50 et 400, de préférence compris entre 70 et 150.

Comme la force électrostatique générée par le module d'entrainement 200 est inversement proportionnelle à l'espacement entre les doigts 213 des peignes fixes 211 et les doigts 223 des peignes mobiles 221, cela a pour effet d'augmenter la puissance motrice générée par le module d'entrainement 200, en s'affranchissant des contraintes d'espacement imposées par la technique de gravure utilisée.

Le deuxième espacement G2 peut être différent du troisième espacement G3, afin de tenir compte du fait qu'au cours du déplacement de la partie mobile d'entrainement 220 par rapport à la partie fixe d'entrainement 210, le déplacement des doigts 223 des peignes mobiles 221 n'est pas parfaitement rectiligne, ni parfaitement parallèle aux doigts 213 des peignes fixes 211.

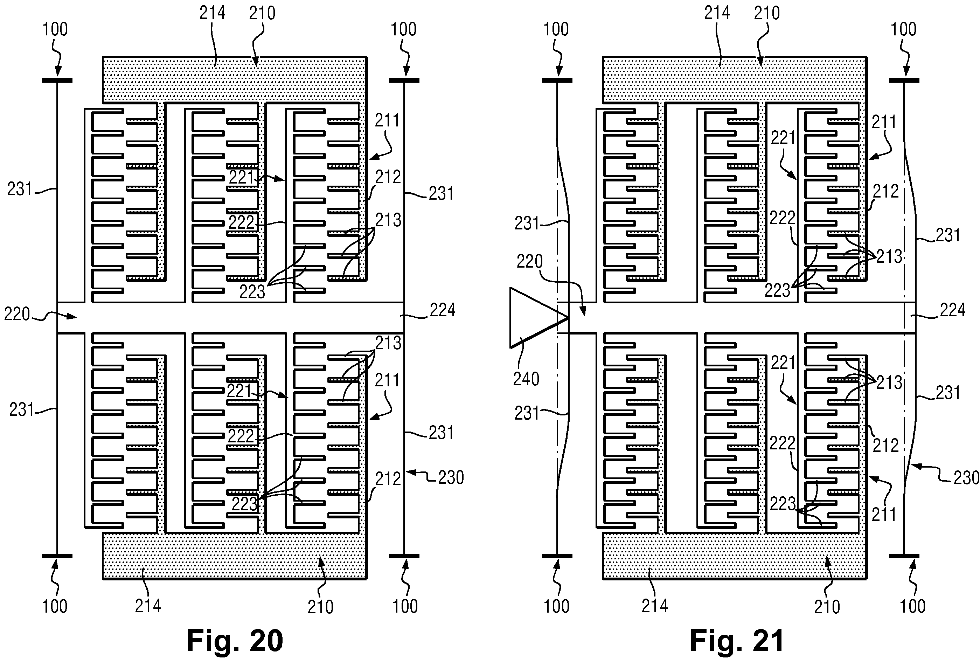

Les figures 20 et 21 représentent de manière schématique un microsystème électromécanique 10 conforme à un autre mode de réalisation possible de l'invention.

Cet autre mode de réalisation diffère du mode de réalisation illustré sur les figures 1 à 6, en ce que le module d'entrainement 200 est symétrique par rapport à un axe de symétrie parallèle à la direction tangentielle.

Comme dans le mode de réalisation des figures 1 à 6, le module d'entrainement 200 comprend une partie fixe d'entrainement 210 et une partie mobile d'entrainement 220.

La partie fixe d'entrainement 210 est montée fixe sur le support 6.

Dans ce mode de réalisation, la partie fixe d'entrainement 210 comprend deux premiers portants 214, une première série de peignes fixes 211 s'étendant perpendiculairement à partir de l'un des premiers portants 214 et une deuxième série de peignes fixes 211 s'étendant perpendiculairement à partir de l'autre des premiers portants 214.

La partie mobile d'entrainement 220 comprend un deuxième portant 224 et une pluralité de peignes mobiles 221 s'étendant perpendiculairement à partir du deuxième portant 224.

Dans ce mode de réalisation, les peignes mobiles 221 comprennent une première série de peignes mobiles s'étendant d'un premier côté du deuxième portant 224 et une deuxième série de peignes mobiles s'étendant d'un deuxième côté du deuxième portant 224, opposé au premier côté. De cette manière, les peignes mobiles 221 s'étendent de manière symétrique de part et d'autre du deuxième portant 224.

De même, les peignes fixes 211 de la première série de peignes fixes s'étendent du premier côté du deuxième portant 224 et les peignes fixes 211 de la deuxième série de peignes fixes s'étendent du deuxième côté du deuxième portant 224, opposé au premier côté. De cette manière, les peignes fixes 211 s'étendent de manière symétrique de part et d'autre du deuxième portant 224.

L'actionneur 11 comprend en outre une première suspension 230 reliant la partie mobile d'entrainement 220 au cadre 100. La première suspension 230 comprend quatre poutres flexibles 231 s'étendant parallèlement aux tiges 222 des peignes mobiles 221. Les poutres flexibles 231 relient le deuxième portant 224 au cadre 100. Les quatre poutres flexibles 231 incluent deux poutres flexibles s'étendant du premier côté du deuxième portant 224 et deux autres poutres flexibles s'étendant du deuxième côté du deuxième portant 224. De cette manière, la première suspension 230 est symétrique par rapport à l'axe de symétrie parallèle à la direction tangentielle

Les peignes mobiles 221 sont agencés en étant intercalés entre les peignes fixes 211. C'est-à-dire que les peignes mobiles 221 sont disposés en alternance avec les peignes fixes 211. De plus, les peignes mobiles 221 et les peignes fixes 211 sont agencés par paires, chaque paire comprenant un peigne fixe 211 et un peigne mobile 221 associé. Plus précisément, les doigts 213 de chaque peigne fixe 211 d'une paire s'étendent avec leurs extrémités libres dirigées vers les doigts 223 du peigne mobile 221 associé de la même paire. De même, les doigts 223 du peigne mobile 221 d'une paire s'étendent avec leurs extrémités libres dirigées vers les doigts 213 du peigne fixe 211 de la même paire. De plus, les doigts 213 des peignes fixes 211 et les doigts 223 des peignes mobiles 221 s'étendent parallèlement à une direction tangentielle.

La figure 20 représente de manière schématique le module d'entrainement 200, avant le verrouillage du mécanisme de verrouillage 500.

Comme illustré sur cette figure, les doigts 223 des peignes mobiles 221 ne sont pas engagés entre les doigts 213 des peignes fixes 211.

De plus, la première suspension 230 se trouve dans une position de repos. C'est-à-dire que les poutres flexibles 231 de la première suspension 230 ne sont pas déformées. La force élastique de rappel exercée par la première suspension 230 est donc nulle.

La figure 21 représente de manière schématique le module d'entrainement 200, après le verrouillage du mécanisme de verrouillage 500.

Comme illustré sur cette figure, les doigts 223 des peignes mobiles 221 sont partiellement engagés dans les espaces ménagés entre les doigts 213 des peignes fixes 211.

Comme la butée 240 empêche un retour de la partie mobile d'entrainement 220 jusqu'à la position de repos, les poutres flexibles 231 sont maintenues dans un état de déformation élastique. De cette manière, la force élastique de rappel exercée par la première suspension 230 n'est pas nulle.

Un avantage de ce mode de réalisation est que, du fait de la configuration symétrique de la première suspension 230, le déplacement des doigts 223 des peignes mobiles 221 est parfaitement rectiligne et parallèle aux doigts 213 des peignes fixes 211, au cours du déplacement de la partie mobile d'entrainement 220 par rapport à la partie fixe d'entrainement 210.

Autrement dit, le deuxième portant 224 est contraint de se déplacer selon une direction tangentielle et ne peut pas se déplacer selon une direction radiale.

Il est ainsi possible de réduire encore l'espacement G2 ou G3 entre les doigts 213 et 223 des peignes fixes 211 et des peignes mobiles 221. De plus, le deuxième espacement G2 et le troisième espacement G3 peuvent être égaux. Les espacements G2 et G3 (illustrés sur la figure 17) peuvent être inférieurs à 1 µm.

Cela permet d'augmenter encore la force électrostatique générée par le module d'entrainement 200.

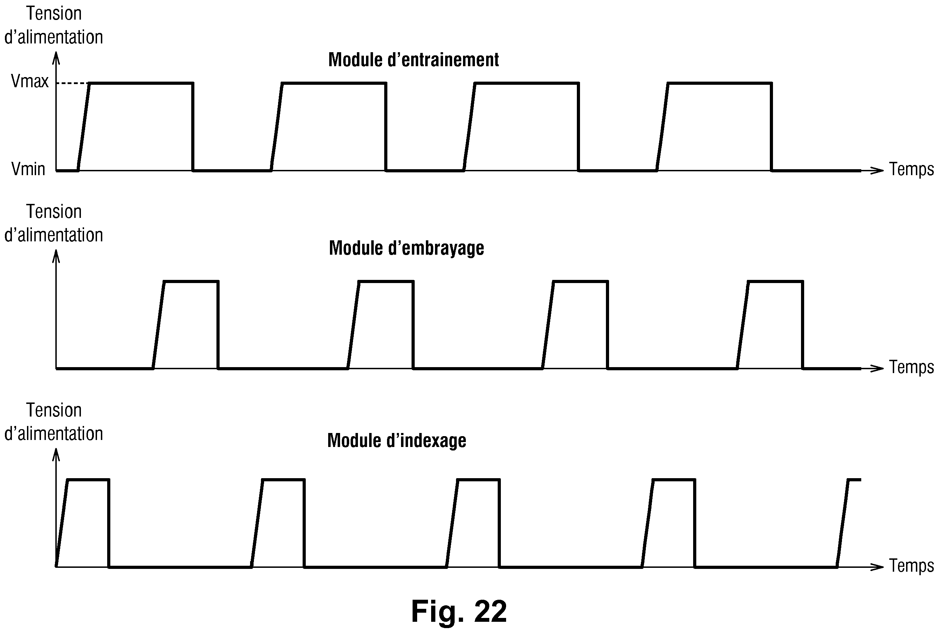

La figure 22 représente de manière schématique un exemple de signal électrique de commande du module d'entrainement, un exemple de signal électrique de commande du module d'embrayage, et un exemple de signal électrique de commande du module d'indexage.

Sur la figure 22, chaque signal électrique de commande est un signal électrique de commande en tension. Le diagramme de la figure 22 représente donc la variation de la tension de chaque signal électrique de commande en fonction du temps. Chaque signal électrique de commande est périodique et présente une forme sensiblement en créneaux.

Par exemple, le signal électrique de commande du module d'entrainement prend en alternance une valeur minimale de tension (par exemple Vmin = 0) et une valeur maximale de tension (par exemple Vmax = 110 Volts).

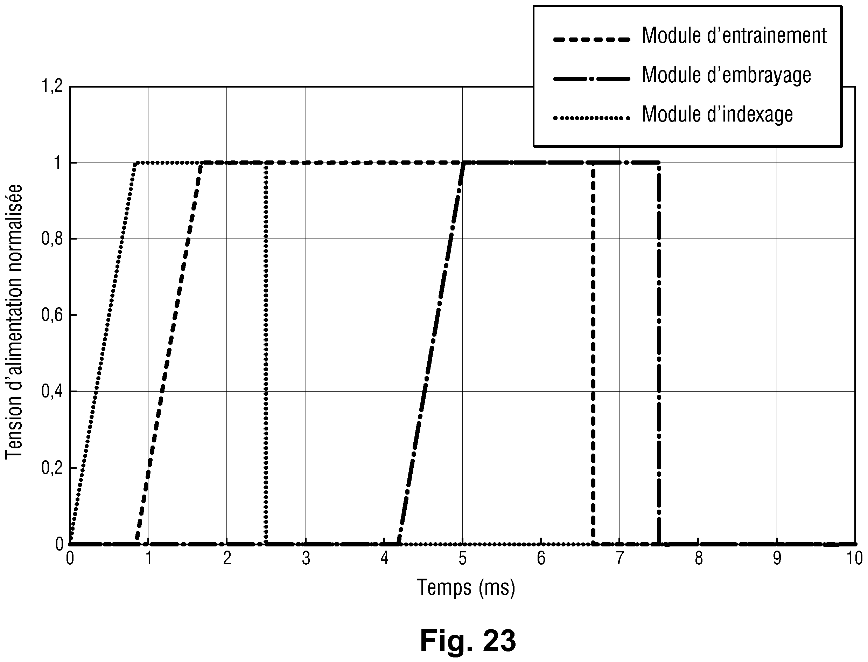

Le diagramme de la figure 23 représente plus précisément la variation de la tension de chaque signal électrique de commande en fonction du temps, au cours d'une période.

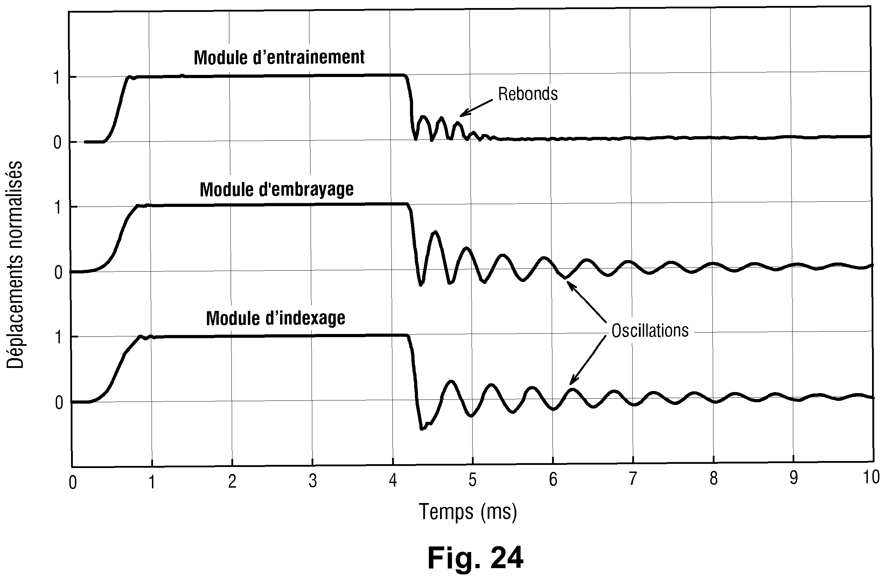

La figure 24 représente de manière schématique le déplacement au cours du temps de la partie mobile d'entrainement 220 du module d'entrainement 200, le déplacement au cours du temps de la partie mobile d'embrayage 320 du module d'embrayage 300 et le déplacement au cours du temps de la partie mobile 420 du module d'indexage 400.

Ces déplacements ont été obtenus lorsque l'actionneur 11 est commandé avec des signaux électriques de commande identiques à ceux qui sont illustrés sur les figures 22 et 23.

La figure 24 montre que la partie mobile d'entrainement 220 du module d'entrainement 200 subit des rebonds. Ces rebonds surviennent essentiellement lorsque la partie mobile d'entrainement 220 parvient en fin de course. Plus précisément, ces rebonds sont visibles lorsque la partie mobile d'entrainement 220 vient en contact avec la butée 240 lors d'un déplacement élémentaire dans le deuxième sens (flèche B), c'est-à-dire lorsque la partie mobile d'entrainement 220 retourne vers sa position initiale sous l'effet de la force élastique de rappel générée par la première suspension 230 ayant été déformée élastiquement.

La figure 24 montre également que la partie mobile d'embrayage 320 du module d'embrayage 300 et la partie mobile d'indexage 420 du module d'indexage 400 subissent également des oscillations résiduelles.

Ces rebonds ou ces oscillations résiduelles sont préjudiciables au bon fonctionnement de l'actionneur 11.

D'une part, il est nécessaire d'attendre que ces rebonds ou ces oscillations soient suffisamment atténués, avant de commander un déplacement de la partie mobile en sens inverse, ce qui limite la fréquence à laquelle l'actionneur peut être commandé.

D'autre part, les rebonds génèrent des chocs répétés entre les pièces mécaniques, qui provoquent une usure prématurée des surfaces en contact, et diminuent la durée de vie du microsystème électromécanique.

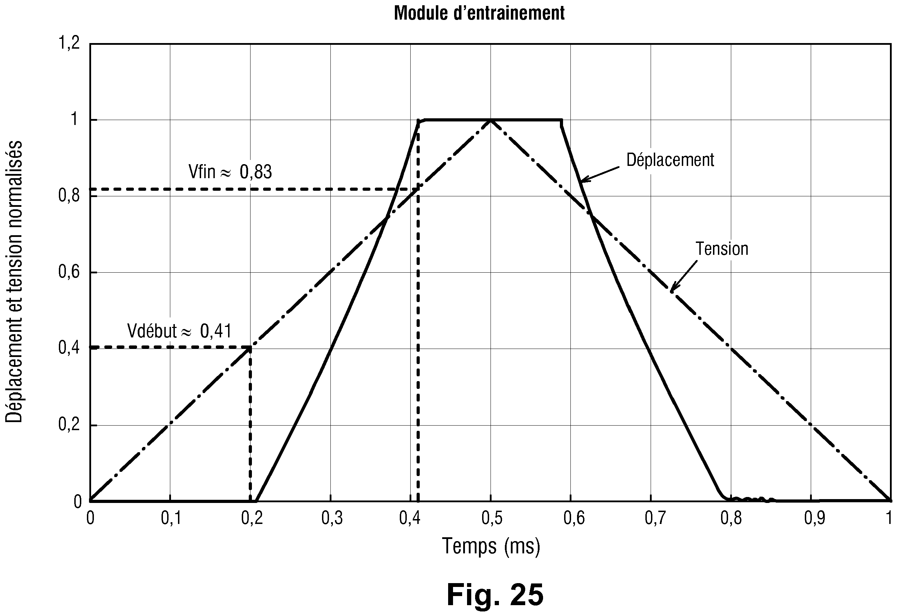

La figure 25 est un diagramme représentant de manière schématique le déplacement de la partie mobile d'entrainement 220 du module d'entrainement 200 en fonction de la valeur de la tension du signal électrique de commande appliqué entre la partie mobile d'entrainement 220 et la partie fixe d'entrainement 210.

Ce diagramme montre plus particulièrement l'amplitude du déplacement de la partie mobile d'entrainement 220 par rapport à la partie fixe d'entrainement 210 lorsque la valeur de la tension du signal électrique de commande appliquée au module d'entrainement 200 augmente progressivement, de manière linéaire, au cours du temps.

Comme cela est visible sur la figure 25, lorsque la valeur de la tension du signal électrique de commande est inférieure à une valeur seuil de tension Vdébut, la partie mobile d'entrainement 220 ne se déplace pas par rapport à la partie fixe d'entrainement 210. En effet, la force électrostatique générée entre la partie mobile d'entrainement 220 et la partie fixe d'entrainement 210 est insuffisante pour surmonter la force élastique de rappel générée par la première suspension 230 et est donc insuffisante pour provoquer un déplacement de la partie mobile d'entrainement 220 par rapport à la partie fixe d'entrainement 210. Autrement dit, la première suspension 230 est soumise à une précontrainte élastique, que la force électrostatique doit surmonter pour pouvoir déplacer la partie mobile d'entrainement 220 par rapport à la partie fixe d'entrainement 210.

Lorsque la valeur de la tension du signal électrique de commande est comprise entre la valeur seuil de tension Vdébut et une valeur seuil de tension Vfin, la partie mobile d'entrainement 220 se déplace par rapport à la partie fixe d'entrainement 210. En effet, la force électrostatique générée entre la partie mobile d'entrainement 220 et la partie fixe d'entrainement 210 provoque un déplacement de la partie mobile d'entrainement 220 par rapport à la partie fixe d'entrainement 210. L'amplitude du déplacement de la partie mobile d'entrainement 220 par rapport à la partie fixe d'entrainement 210 augmente continument avec la valeur de la tension du signal électrique de commande.

Lorsque la valeur de la tension du signal de commande est supérieure à la tension Vfin, la partie mobile d'entrainement 220 ne se déplace plus par rapport à la partie fixe d'entrainement 210. En effet, la partie mobile d'entrainement 220 est en butée contre le cadre 100. Ainsi, une augmentation de la force électrostatique ne provoque pas de déplacement additionnel de la partie mobile d'entrainement 220 par rapport à la partie fixe d'entrainement 210.

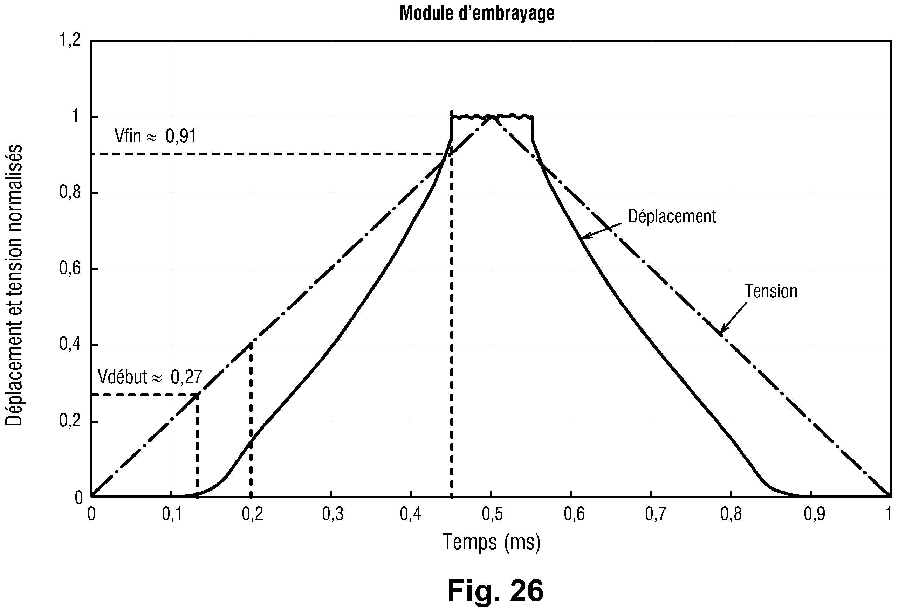

La figure 26 est un diagramme représentant de manière schématique le déplacement de la partie mobile d'embrayage 320 du module d'embrayage 300 en fonction de la valeur de la tension du signal électrique de commande appliqué au module d'embrayage 300.

Comme pour le module d'entrainement 200, il est possible de déterminer une valeur seuil de tension Vdébut au-dessous de laquelle la force électrostatique générée entre la partie mobile d'embrayage 320 et la partie fixe d'embrayage 310 est insuffisante pour provoquer un déplacement de la partie mobile d'embrayage 320 par rapport à la partie fixe d'embrayage 310.

Dans le cas du module d'embrayage 300, lorsque la valeur de la tension du signal électrique de commande est inférieure à la valeur seuil de tension Vdébut, la partie mobile d'embrayage 320 ne se déplace pas par rapport à la partie fixe d'embrayage 310. En effet, comme les doigts 323 des peignes mobiles 321 ne sont pas engagés avec les doigts 313 des peignes fixes 311, la force électrostatique générée entre les peignes fixes 311 et les peignes mobiles 321 est très faible.

Il est également possible de déterminer une valeur seuil de tension Vfin au-dessus de laquelle la partie mobile d'embrayage 320 est en butée contre le cadre 100.

Lorsque la tension du signal de commande est comprise entre la valeur seuil de tension Vdébut et la valeur seuil de tension Vfin, la partie mobile d'embrayage 320 se déplace par rapport à la partie fixe d'embrayage 310. L'amplitude du déplacement de la partie mobile d'embrayage 320 par rapport à la partie fixe d'embrayage 310 augmente continument avec la valeur de la tension du signal électrique de commande.

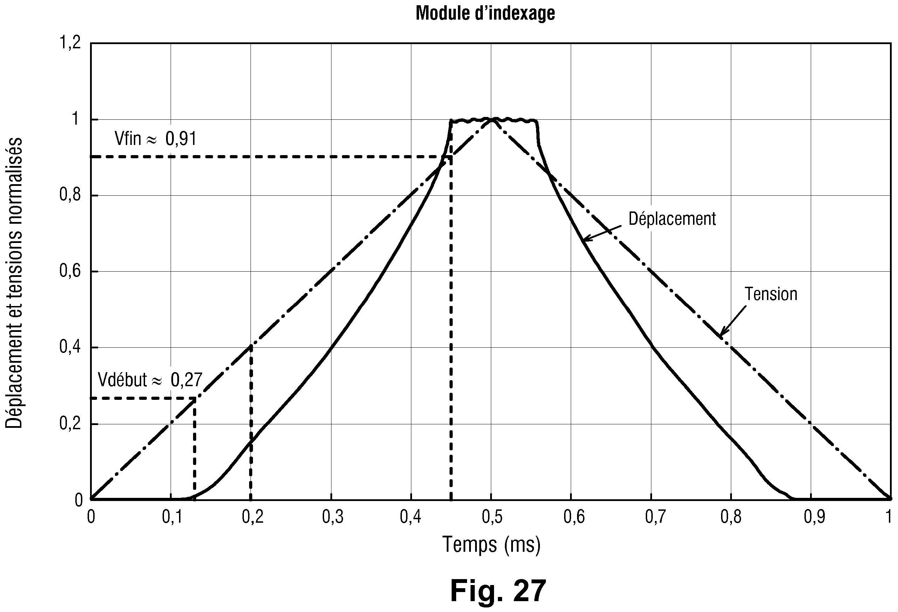

La figure 27 est un diagramme représentant de manière schématique le déplacement de la partie mobile d'indexage 420 du module d'indexage 400 en fonction de la valeur de la tension du signal électrique de commande appliqué au module d'indexage 400.

Comme pour le module d'embrayage 300, il est possible de déterminer une valeur seuil de tension Vdébut au-dessous de laquelle la force électrostatique générée entre la partie mobile d'indexage 420 et la partie fixe d'indexage 410 est insuffisante pour provoquer un déplacement de la partie mobile d'indexage 420 par rapport à la partie fixe d'indexage 410.

Il est également possible de déterminer une valeur seuil de tension Vfin au-dessus de laquelle la partie mobile d'indexage 420 est en butée contre le cadre 100.

Lorsque la tension du signal de commande est comprise entre la valeur seuil de tension Vdébut et la valeur seuil de tension Vfin, la partie mobile d'indexage 420 se déplace par rapport à la partie fixe d'indexage 410. L'amplitude du déplacement de la partie mobile d'indexage 420 par rapport à la partie fixe d'indexage 410 augmente continument avec la valeur de la tension du signal électrique de commande.

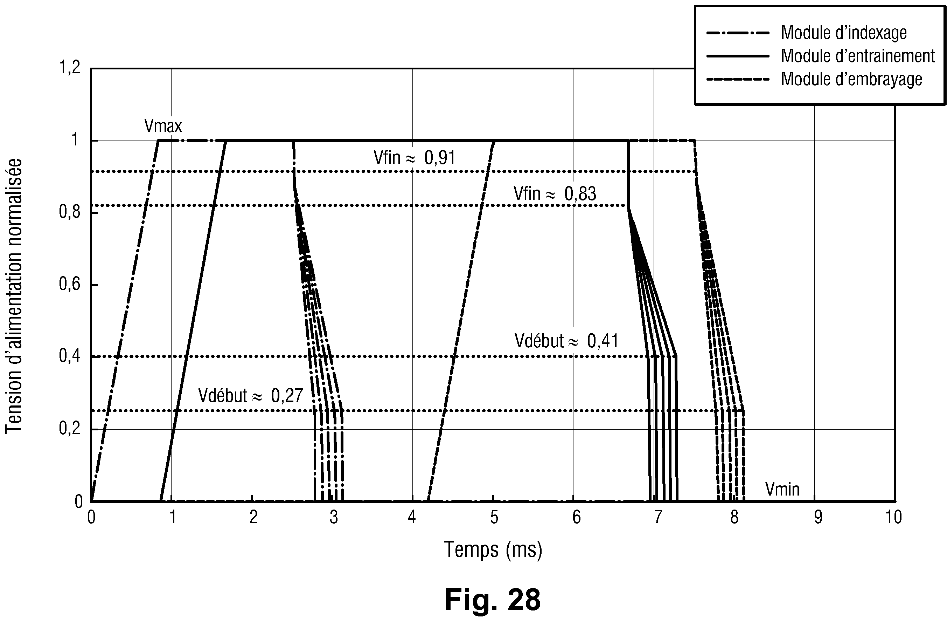

La figure 28 est un diagramme représentant de manière schématique un signal électrique de commande du module d'entrainement 200, un signal électrique de commande du module d'embrayage 300, et un signal électrique de commande du module d'indexage 400, conformes à un mode de réalisation possible de l'invention.

Comme illustré sur cette figure, le signal électrique de commande du module d'entrainement 200 prend en alternance une valeur minimale de tension (par exemple Vmin = 0) et une valeur maximale de tension (par exemple Vmax = 110 volts).

Au cours du passage de la valeur maximale de tension Vmax à la valeur minimale de tension Vmin, la valeur de la tension du signal électrique de commande diminue de façon monotone depuis la valeur maximale de tension Vmax jusqu'à la valeur minimale de tension Vmin.

De plus, au cours de cette diminution, le signal électrique de commande présente successivement :
- une première pente moyenne entre la valeur maximale de tension Vmax et la valeur seuil de tension Vfin définie pour le module d'entrainement (dans cet exemple Vfin ≈ 0,83 x Vmax),
- une deuxième pente moyenne, inférieure en valeur absolue à la première pente moyenne, entre la valeur seuil de tension Vfin et la valeur seuil de tension Vdébut (dans cet exemple, Vdébut ≈ 0,41 x Vmax), et
- une troisième pente moyenne, supérieure en valeur absolue à la deuxième pente moyenne, entre la valeur seuil de tension Vdébut définie pour le module d'entrainement et la valeur minimale de tension Vmin (dans cet exemple Vmin = 0).

La première pente moyenne est définie comme étant une moyenne de la pente instantanée du signal électrique de commande sur l'intervalle de temps [Tmax, Tfin] au cours duquel la valeur du signal électrique de commande passe de la valeur Vmax à la valeur Vfin. Autrement dit, la première pente moyenne est égale à : (Vfin - Vmax) / (Tfin - Tmax), où (Tfin - Tmax) est le temps mis par le signal électrique de commande pour passer de la valeur Vmax à la valeur Vfin.

La deuxième pente moyenne est définie comme étant une moyenne de la pente instantanée du signal électrique de commande sur l'intervalle de temps [Tfin, Tdébut] au cours duquel la valeur du signal électrique de commande passe de la valeur Vfin à la valeur Vdébut. Autrement dit, la deuxième pente moyenne est égale à : (Vdébut - Vfin) / (Tdébut - Tfin), où (Tdébut - Tfin) est le temps mis par le signal électrique de commande pour passer de la valeur Vfin à la valeur Vdébut.

La troisième pente moyenne est définie comme étant une moyenne de la pente instantanée du signal électrique de commande sur l'intervalle de temps [Tdébut, Tmin] au cours duquel la valeur du signal électrique de commande passe de la valeur Vdébut à la valeur Vmin. Autrement dit, la troisième pente moyenne est égale à : (Vmin - Vdébut) / (Tmin - Tdébut), où (Tmin - Tdébut) est le temps mis par le signal électrique de commande pour passer de la valeur Vdébut à la valeur Vmin.

Dans l'exemple illustré sur la figure 28, le signal électrique de commande est linéaire sur chaque intervalle de temps [Tmax, Tfin], [Tfin, Tdébut] et [Tdébut, Tmin]. Dans ce cas, la première pente moyenne est égale à la pente instantanée du signal qui est constante sur l'intervalle de temps [Tmax, Tfin], la deuxième pente moyenne est égale à la pente instantanée du signal qui est constante sur l'intervalle de temps [Tfin, Tdébut] et la troisième pente moyenne est égale à la pente instantanée du signal qui est constante sur l'intervalle de temps [Tdébut, Tmin].

Toutefois, d'autres formes du signal électrique de commande sont bien entendu possibles, par exemple des formes où le signal électrique de commande n'est pas linéaire sur chaque intervalle.

Sur la figure 28, plusieurs valeurs possibles pour la deuxième pente moyenne ont été illustrées.

Comme illustré sur la figure 28, le signal électrique de commande du module d'embrayage 300, et le signal électrique de commande du module d'indexage 400, présentent une forme analogue à celle du signal électrique de commande du module d'entrainement 200.

Comme illustré sur cette figure, le signal électrique de commande du module d'embrayage 300 (respectivement du module d'indexage 400) prend en alternance une valeur minimale de tension (par exemple Vmin = 0) et une valeur maximale de tension (par exemple Vmax = 110 volts).

Au cours du passage de la valeur maximale de tension à la valeur minimale de tension, la valeur de la tension du signal électrique de commande diminue de façon monotone depuis la valeur maximale de tension Vmax jusqu'à la valeur minimale de tension Vmin.

De plus, au cours de cette diminution, le signal électrique de commande présente successivement :
- une première pente moyenne entre la valeur maximale de tension et la valeur seuil de tension Vfin définie pour le module d'embrayage 300 (respectivement du module d'indexage 400) (dans cet exemple Vfin ≈ 0,91 x Vmax),
- une deuxième pente moyenne, inférieure en valeur absolue à la première pente moyenne, entre la valeur seuil de tension Vfin et la valeur seuil de tension Vdébut (dans cet exemple, Vdébut ≈ 0,27 Vmax), et
- une troisième pente moyenne, supérieure en valeur absolue à la deuxième pente moyenne, entre la valeur seuil de tension Vdébut définie pour le module d'embrayage 300 (respectivement du module d'indexage 400) et la valeur minimale de tension Vmin (dans cet exemple Vmin = 0).

Sur la figure 28, plusieurs valeurs possibles pour la deuxième pente moyenne ont été illustrées.

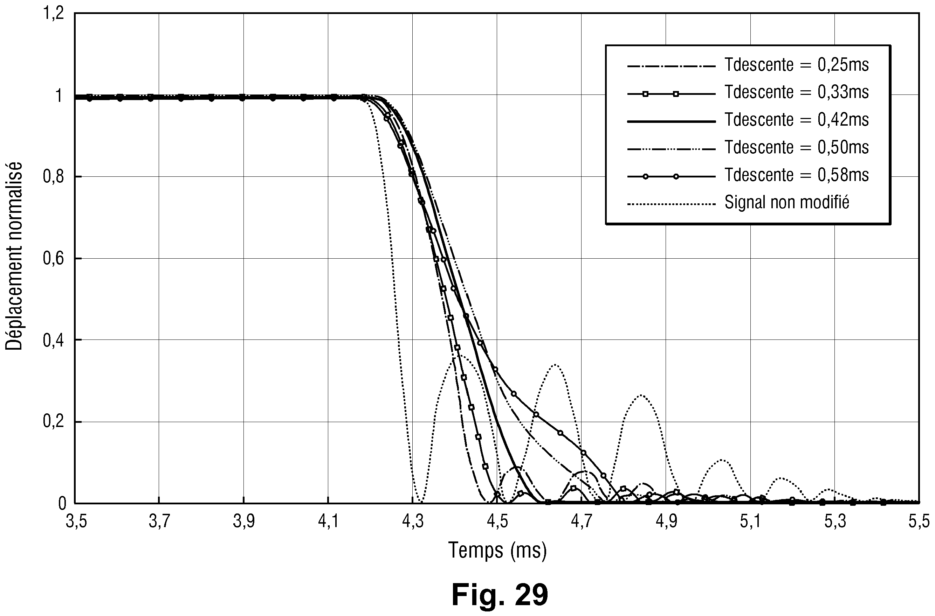

La figure 29 est un diagramme représentant de manière schématique l'amplitude du déplacement de la partie mobile d'entrainement 220 par rapport à la partie fixe d'entrainement 210, au cours du temps, obtenu lorsque le module d'entrainement 200 est commandé avec les signaux électriques de commande de la figure 28.

En fonction de la deuxième pente moyenne choisie pour le signal électrique de commande appliqué au module d'entrainement 200 (c'est-à-dire en fonction du temps mis par le signal de commande pour passer de la valeur de tension Vfin à la valeur de tension Vdébut), les rebonds de la partie mobile 220 sont plus ou moins atténués.

Il est possible de déterminer une valeur optimale pour la deuxième pente moyenne (ou une valeur optimale du temps mis par le signal de commande pour passer de la valeur de tension Vfin à la valeur de tension Vdébut), c'est-à-dire une valeur de la deuxième pente moyenne qui permet d'obtenir la meilleure atténuation de ces rebonds.

Dans l'exemple illustré sur la figure 29, le temps mis par le signal de commande pour passer de la valeur de tension Vfin à la valeur de tension Vdébut qui permet la meilleure atténuation des rebonds est de 0,42 ms. Ce temps est sensiblement égal à une période propre d'oscillation libre de la partie mobile d'entrainement 220 par rapport à la partie fixe d'entrainement 210. Par exemple, ce temps est compris dans une plage allant de 0,7 à 1,3 fois la période propre d'oscillation libre de la partie mobile d'entrainement 220 par rapport à la partie fixe d'entrainement 210.

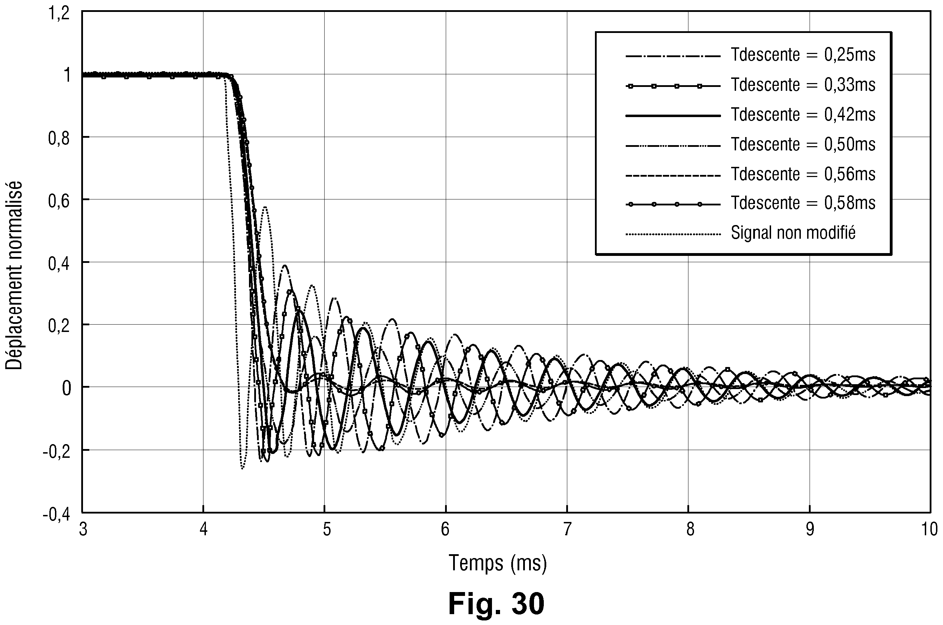

De même, la figure 30 est un diagramme représentant de manière schématique l'amplitude du déplacement de la partie mobile d'embrayage 320 par rapport à la partie fixe d'embrayage 310 du module d'embrayage 300, au cours du temps, obtenu lorsque le module d'embrayage 300 est commandé avec les signaux électriques de commande de la figure 28.

Dans cet exemple, le temps mis par le signal de commande pour passer de la valeur de tension Vfin à la valeur de tension Vdébut qui permet la meilleure atténuation des oscillations est de 0,56 ms. Ce temps est sensiblement égal à une période propre d'oscillation libre de la partie mobile d'embrayage 320 par rapport à la partie fixe d'embrayage 310.

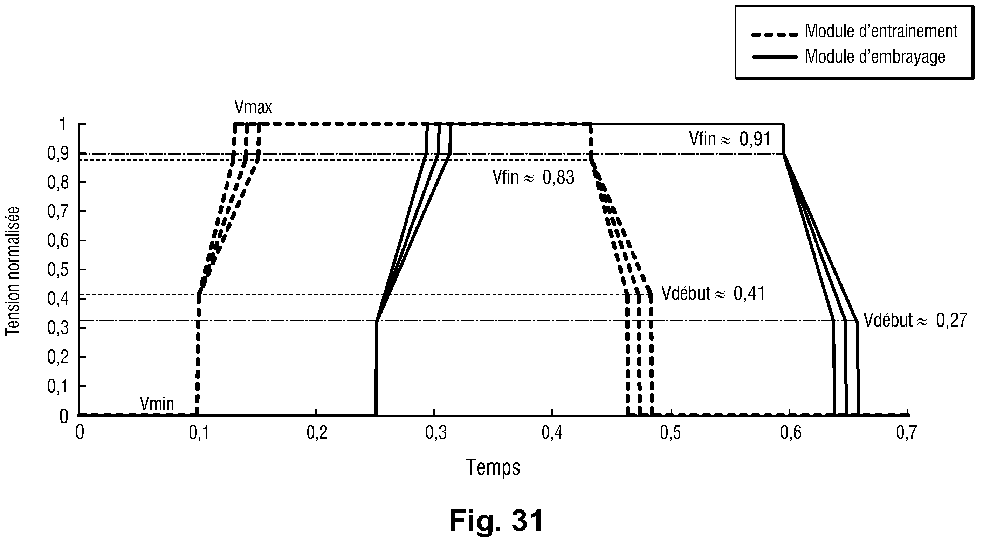

La figure 31 est un diagramme représentant de manière schématique des signaux électriques de commande du module d'entrainement et des signaux électriques de commande du module d'embrayage, conformes à un autre mode de réalisation possible de l'invention.

Dans ce mode de réalisation, comme dans le mode de réalisation précédent, le signal de commande prend en alternance une valeur minimale de tension Vmin et une valeur maximale de tension Vmax.

Cependant, dans ce mode de réalisation, au cours du passage de la valeur minimale de tension à la valeur maximale de tension, la valeur de tension du signal électrique de commande augmente de façon monotone depuis la valeur minimale de tension jusqu'à la valeur maximale de tension.

De plus, la valeur de tension du signal électrique de commande présente successivement :
- une quatrième pente moyenne entre la valeur minimale de tension Vmin et la valeur seuil de tension Vdébut,
- une cinquième pente moyenne, inférieure en valeur absolue à la quatrième pente moyenne, entre la valeur seuil de tension Vdébut et la valeur seuil de tension Vfin, et
- une sixième pente moyenne, supérieure en valeur absolue à la cinquième pente moyenne, entre la valeur seuil de tension Vfin et la valeur maximale de tension Vmax.

La quatrième pente moyenne est définie comme étant une moyenne de la pente instantanée du signal électrique de commande sur l'intervalle de temps [Tmin, Tdébut] au cours duquel la valeur du signal électrique de commande passe de la valeur Vmin à la valeur Vdébut. Autrement dit, la quatrième pente moyenne est égale à : (Vdébut - Vmin) / (Tdébut - Tmin), où (Tdébut - Tmin) est le temps mis par le signal électrique de commande pour passer de la valeur Vmin à la valeur Vdébut.

La cinquième pente moyenne est définie comme étant une moyenne de la pente instantanée du signal électrique de commande sur l'intervalle de temps [début, Tfin] au cours duquel la valeur du signal électrique de commande passe de la valeur Vdébut à la valeur Vfin. Autrement dit, la cinquième pente moyenne est égale à : (Vfin - Vdébut) / (Tfin - Tdébut), où (Tfin - Tdébut) est le temps mis par le signal électrique de commande pour passer de la valeur Vdébut à la valeur Vfin.

La sixième pente moyenne est définie comme étant une moyenne de la pente instantanée du signal électrique de commande sur l'intervalle de temps [Tfin, Tmax] au cours duquel la valeur du signal électrique de commande passe de la valeur Vfin à la valeur Vmax. Autrement dit, la sixième pente moyenne est égale à : (Vmax - Vfin) / (Tmax - Tfin), où (Tmax - Tfin) est le temps mis par le signal électrique de commande pour passer de la valeur Vfin à la valeur Vmax.

Dans l'exemple illustré sur la figure 31, le signal électrique de commande est linéaire sur chaque intervalle de temps [Tmin, Tdébut], [Tdébut, Tfin] et [Tfin, Tmax]. Dans ce cas, la quatrième pente moyenne est égale à la pente instantanée du signal qui est constante sur l'intervalle de temps [Tmin, Tdébut], la cinquième pente moyenne est égale à la pente instantanée du signal qui est constante sur l'intervalle de temps [Tdébut, Tfin] et la sixième pente moyenne est égale à la pente instantanée du signal qui est constante sur l'intervalle de temps [Tfin, Tmax].

Toutefois, d'autres formes du signal électrique de commande sont bien entendu possibles, par exemple des formes où le signal électrique de commande n'est pas linéaire sur chaque intervalle.

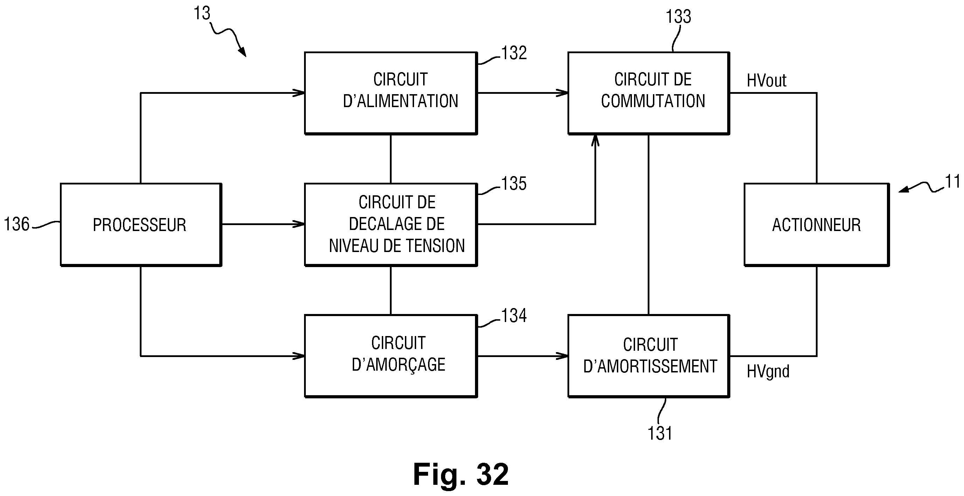

La figure 32 représente de manière schématique un circuit de commande 13 adapté pour commander l'actionneur 11 du microsystème électromécanique 10.

Dans cet exemple, le circuit de commande 13 comprend :
- un circuit d'amortissement 131,
- un circuit d'alimentation 132 comprenant un convertisseur à pompe de charge et un régulateur de tension, le circuit d'alimentation 132 étant configuré pour générer un signal d'alimentation haute tension,
- un circuit de commutation 133 comprenant des interrupteurs haute tension, le circuit de commutation étant configuré pour raccorder l'actionneur 11 sélectivement à la sortie circuit d'alimentation 132 et au circuit d'amortissement 131,
- un circuit d'amorçage 134 configuré pour piloter le circuit d'amortissement,
- un circuit de décalage de niveau de tension 135,
- un microprocesseur numérique basse tension 136.

Le circuit d'amortissement 131, le circuit d'alimentation 132, le circuit de commutation 133, le circuit d'amorçage 134 et le circuit de décalage de niveau de tension 135 peuvent être des composants d'un même circuit ASIC.

Le processeur numérique 136 (appelé également « Low voltage digital core ») est un processeur numérique basse tension programmable qui est configuré pour piloter les différents composants du circuit ASIC.

Le circuit d'alimentation 132 est par exemple configuré pour générer un signal d'alimentation haute tension caractérisé par une tension maximale de 125 Volts, possiblement régulée entre deux valeurs inférieures à la tension maximale et un temps de montée variable inférieur à 1 ms selon la fréquence de fonctionnement de la pompe à charge.

La pompe de charge est un circuit analogique comprenant des condensateurs permettant d'amplifier la tension du signal électrique de commande appliqué à l'entrée du circuit de commutation 133 (la pompe de charge est également appelée » multiplicateur de tension »). Ce circuit analogique permet par exemple de passer d'une tension d'entrée de 1.5 à 3 Volts d'une batterie classique (pile bouton) à une tension de sortie supérieure à 100 Volts requise pour l'alimentation des modules 200, 300 et 400 de l'actionneur 11.

Les interrupteurs du circuit de commutation 133 sont configurés pour permettre la commutation entre la borne haute tension (110 Volts) requise pour la montée en tension du signal électrique de commande appliqué à l'actionneur 11 et le circuit d'amortissement 131. Ces interrupteurs comprennent par exemple un ou plusieurs transistor(s) MOSFET de puissance capable(s) de supporter des hautes tensions.

Le circuit d'amorçage 134 (appelé également « VDD Bootstrap ») est configuré pour commander les transistors MOSFET du circuit d'amortissement 131. Le circuit d'amorçage 134 est un circuit analogique permettant d'adapter, de convertir et d'injecter un signal de commande numérique basse tension généré par le processeur numérique 136 à la grille du transistor MOSFET du circuit d'amortissement 131.

Le circuit de décalage de niveau de tension 135 (appelé également « High Voltage Level Shifter ») est un circuit analogique configuré pour convertir le signal de commande numérique basse tension généré par le processeur numérique 136 en un signal de commande haute tension appliqué à la grille du transistor MOSFET du circuit de commutation 133.

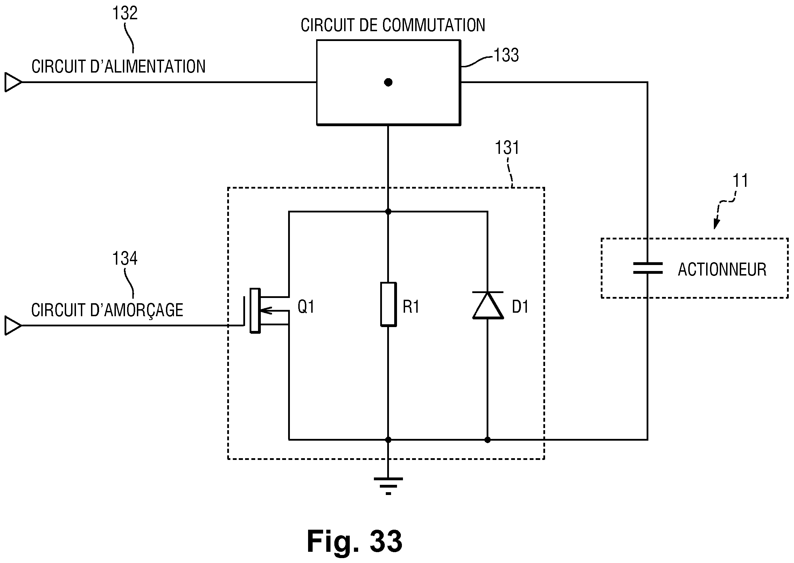

La figure 33 représente de manière schématique le circuit d'amortissement 131 faisant partie du circuit de commande 13 de la figure 18.

Sur cette figure, l'actionneur 11 a été assimilé à un condensateur. En effet, le module d'entrainement 200, le module de débrayage 300 et le module d'indexage comprennent chacun une partie mobile et une parte fixe. La partie mobile et la partie fixe peuvent être assimilées à des armatures d'un condensateur.

Sur la figure 33, seul le module d'entrainement 200 a été représenté. Toutefois, le schéma du circuit d'amortissement 131 est identique pour les trois modules.

Le circuit d'amortissement 131 comprend une diode D1, une résistance R1 et un transistor MOSFET Q1. La diode D1, la résistance R1 et le transistor MOSFET Q1 sont raccordés électriquement selon un montage en parallèle entre le circuit de commutation 133 et la terre.

Le transistor MOSFET Q1 est piloté par le circuit d'amorçage 134. Le circuit d'amorçage 134 est raccordé à la grille du transistor et est configuré pour piloter le transistor de manière à sélectivement bloquer le transistor ou activer le transistor.

Lorsque le transistor MOSFET Q1 est bloqué, aucun courant électrique ne passe à travers le transistor (entre le drain et la source).

Lorsque le transistor MOSFET Q1 est activé, un courant électrique peut passer à travers le transistor.

Le fonctionnement du circuit de commande 13 est le suivant.

Le transistor MOSFET Q1 est initialement bloqué.

Lorsque la tension du signal d'alimentation haute tension passe de la valeur de tension minimale (Vmin) à la valeur de tension maximale (Vmax), le module de commutation 133 est dans une première configuration dans laquelle le module de commutation 133 raccorde l'actionneur 11 à la sortie circuit d'alimentation 132. L'actionneur 11 est donc alimenté par le signal d'alimentation haute tension généré par le circuit d'alimentation 132.

Lorsque la tension du signal d'alimentation haute tension passe de la valeur de tension maximale (Vmax) à la valeur de tension minimale (Vmin), le circuit de commutation 133 passe dans une deuxième configuration dans laquelle le module de commutation 133 raccorde l'actionneur 11 au circuit d'amortissement 131.

Ainsi, lorsque le circuit de commutation 133 se trouve dans la deuxième configuration, le module d'entrainement 200 se décharge à travers le circuit d'amortissement 131.

La décharge du module d'entrainement 200 se déroule en trois phases successives.

Initialement, la tension entre la partie fixe d'entrainement 210 et la partie mobile d'entrainement 220 est égale à la valeur maximale de tension Vmax. Au cours de la décharge du module d'entrainement 200, la tension entre la partie fixe d'entrainement 210 et la partie mobile d'entrainement 220 diminue.

Tant que la tension entre la partie fixe d'entrainement 210 et la partie mobile d'entrainement 220 est supérieure à la valeur seuil de tension Vfin (première phase), le courant de décharge de l'actionneur 11 passe à travers la diode D1. La tension aux bornes du module d'entrainement 200 diminue brutalement depuis la valeur maximale de tension Vmax jusqu'à la valeur seuil de tension Vfin. La variation de la tension aux bornes du module d'entrainement 200 depuis la valeur maximale de tension Vmax jusqu'à la valeur seuil de tension Vfin présente une première pente. Dans cet exemple, la première pente moyenne est quasi-verticale. Autrement dit, la première pente moyenne est inférieure à -1V / µs. Le temps mis par le signal électrique de commande pour passer de la valeur maximale de tension Vmax à la valeur seuil de tension Vfin (Tfin - Tmax) est inférieur à 50 µs, voire inférieur à 10 µs.

Lorsque la tension entre la partie fixe d'entrainement 210 et la partie mobile d'entrainement 220 devient inférieure à la valeur seuil de tension Vfin (deuxième phase), la diode D1 n'est plus passante. Le courant de décharge de l'actionneur 11 passe à travers la résistance R1. La tension entre la partie fixe d'entrainement 210 et la partie mobile d'entrainement 220 diminue depuis la valeur seuil de tension Vfin jusqu'à la valeur seuil de tension Vdébut. La variation de la tension aux bornes du module d'entrainement 200 présente une deuxième pente moyenne qui dépend de la valeur de la résistance R1. La deuxième pente moyenne est inférieure en valeur absolue à la première pente moyenne. Autrement dit, la diminution de la tension entre la partie fixe d'entrainement 210 et la partie mobile d'entrainement 220 est moins rapide qu'au cours de la première phase. La résistance R1 sert à amortir le déplacement de la partie mobile d'entrainement 220 par rapport à la partie fixe d'entrainement 210.

Lorsque la tension entre la partie fixe d'entrainement 210 et la partie mobile d'entrainement 220 devient inférieure à la valeur seuil de tension Vdébut (troisième phase), le transistor MOSFET Q1 est activé. Ainsi, le courant de décharge de l'actionneur 11 passe à travers le transistor MOSFET Q1. La tension aux bornes du module d'entrainement 200 diminue brutalement depuis la valeur seuil de tension Vdébut jusqu'à la valeur de tension minimale Vmin. La variation de la tension aux bornes du module d'entrainement 200 présente une troisième pente moyenne. Dans cet exemple, la troisième pente est quasi-verticale. Autrement dit, la troisième pente moyenne est inférieure à -1V / µs. Le temps mis par le signal électrique de commande pour passer de la valeur maximale de tension Vdébut à la valeur seuil de tension Vmin (Tmin - Tdébut) est inférieur à 50 µs, voire inférieur à 10 µs. La troisième pente est supérieure en valeur absolue à la deuxième pente.

Dans la pratique, le circuit d'amorçage 134 pilote le transistor MOSFET Q1 de sorte que pendant la première phase et pendant la deuxième phase, le transistor est bloqué, et que pendant la troisième phase, le transistor MOSFET Q1 est activé. A cet effet, le circuit d'amorçage 134 génère un signal électrique de pilotage qui présente une période adaptée pour bloquer et activer le transistor MOSFET Q1 en alternance, de manière synchronisée avec le signal d'alimentation haute tension généré par le circuit d'alimentation 132. La synchronisation des deux signaux est obtenue par le fait que le circuit d'alimentation 132 et le circuit d'amorçage 134 sont pilotés par le processeur numérique 136.

## Revendications

1. Microsystème électromécanique (10), comprenant un support (6) et un actionneur (11), l'actionneur (11) comprenant un module d'entrainement (200) comprenant :
- une partie fixe d'entrainement (210), montée fixe sur le support (6), et comprenant un peigne fixe (211) avec des doigts (213), et
- une partie mobile d'entrainement (220) montée mobile par rapport au support (6), et comprenant un peigne mobile (221) avec des doigts (223),
- un mécanisme de verrouillage (500) mobile entre une configuration initiale déverrouillée et une configuration finale verrouillée,
dans lequel le peigne mobile (221) est agencé face au peigne fixe (211), de sorte que lorsque le mécanisme de verrouillage (500) est dans la configuration initiale déverrouillée, les doigts (223) du peigne mobile (221) ne sont pas engagés entre les doigts (213) du peigne fixe (211), et une fois que le mécanisme de verrouillage (500) est dans la configuration finale verrouillée, les doigts (223) du peigne mobile (221) sont engagés entre les doigts (213) du peigne fixe (211) et le mécanisme de verrouillage (500) empêche un désengagement des doigts (223) du peigne mobile (221) d'entre les doigts (213) du peigne fixe (211),
**caractérisé en ce que** dans la configuration finale verrouillée le mécanisme de verrouillage autorise un déplacement de la partie mobile d'entrainement (220) par rapport à la partie fixe d'entrainement (210) tout au long du fonctionnement ultérieur de l'actionneur (11).

2. Microsystème selon la revendication 1, dans lequel lorsque le mécanisme de verrouillage (500) est dans la configuration initiale déverrouillée, les doigts (223) du peigne mobile (221) sont espacés des doigts (213) du peigne fixe (211) avec un premier espacement (G1), et lorsque le mécanisme de verrouillage (500) est dans la configuration finale verrouillée, les doigts (223) du peigne mobile (221) sont espacés des doigts (213) du peigne fixe (211) avec un deuxième espacement (G2, G3), inférieur au premier espacement (G1).

3. Microsystème selon l'une des revendications 1 et 2, dans lequel le deuxième espacement (G2, G3) est compris entre 0,1 et 5 µm, de préférence compris entre 1 et 3 µm.

4. Microsystème selon l'une des revendications 1 à 3, dans lequel un rapport entre une hauteur des doigts (213, 223) et le deuxième espacement (G2, G3) entre les doigts (213) du peigne fixe (211) et les doigts (223) du peigne mobile (221) est compris entre 50 et 400, de préférence compris entre 70 et 150.

5. Microsystème selon l'une des revendications 1 à 4, dans lequel l'actionneur (11) comprend une butée (240) qui, une fois que le mécanisme de verrouillage (500) est dans la configuration finale verrouillée, empêche un déplacement de la première partie mobile (220) tendant à désengager les doigts (223) du peigne mobile (221) d'entre les doigts (213) du peigne fixe (211).

6. Microsystème selon la revendication 5, dans lequel le mécanisme de verrouillage (500) comprend au moins un premier ergot d'encliquetage (512) relié à la butée (240) et un deuxième ergot d'encliquetage (112) relié au support (6), le premier ergot d'encliquetage (512) étant propre à être mis en prise avec le deuxième ergot d'encliquetage (112) lorsque le mécanisme de verrouillage (500) est en configuration finale verrouillée.

7. Microsystème selon la revendication 6, dans lequel une fois le premier ergot d'encliquetage (512) mis en prise avec le deuxième ergot d'encliquetage (112), le premier ergot d'encliquetage (512) et le deuxième ergot d'encliquetage (112) empêchent un retour du mécanisme de verrouillage vers la configuration initiale déverrouillée.

8. Microsystème selon l'une des revendications 1 à 7, comprenant une suspension (230) reliant la partie mobile d'entrainement (220) au support (6), et dans lequel la partie mobile d'entrainement (220) est propre à être déplacée par rapport à la partie fixe d'entrainement (210) dans un premier sens (A), sous l'effet d'une force électrostatique générée par l'application d'une tension non-nulle entre la partie fixe d'entrainement (210) et la partie mobile d'entrainement (220), le déplacement de la partie mobile d'entrainement (220) par rapport à la partie fixe d'entrainement (210) provoquant une déformation élastique de la suspension (230), et la partie mobile d'entrainement (220) est propre à être déplacée par rapport à la partie fixe d'entrainement (210) dans un deuxième sens (B), opposé au premier sens (A), lorsque la tension appliquée diminue, sous l'effet d'une force élastique de rappel générée par la suspension (230) ayant été déformée élastiquement, la force élastique de rappel étant opposée à la force électrostatique.

9. Microsystème selon la revendication 8, dans lequel le mécanisme de verrouillage (500) comprend un poussoir (510), le poussoir (510) étant agencé de sorte que lorsque la partie mobile d'entrainement (220) est déplacée pour la première fois par rapport à la partie fixe d'entrainement (210) dans le premier sens (A), la partie mobile d'entrainement (220) pousse le poussoir (510) dans le premier sens, ce qui a pour effet de faire passer le mécanisme de verrouillage (500) de la configuration initiale déverrouillée à la configuration finale verrouillée.

10. Microsystème selon la revendication 9, dans lequel le mécanisme de verrouillage (500) comprend une poutre flexible (520) reliant le poussoir (510) au support, la poutre flexible (520) étant déformée sous l'effet du déplacement du poussoir (510) dans le premier sens (A).

## Patentansprüche

1. Elektromechanisches Mikrosystem (10), das einen Träger (6) und einen Aktuator (11) umfasst, wobei der Aktuator (11) ein Antriebsmodul (200) umfasst, das umfasst:
- einen festen Antriebsteil (210), der fest am Träger (6) angebracht ist und einen festen Kamm (211) mit Fingern (213) umfasst, und
- einen beweglichen Antriebsteil (220), der in Bezug auf den Träger (6) beweglich angebracht ist und einen beweglichen Kamm (221) mit Fingern (223) umfasst,
- einen Verriegelungsmechanismus (500), der zwischen einer entriegelten Anfangskonfiguration und einer verriegelten Endkonfiguration beweglich ist,
wobei der bewegliche Kamm (221) dem festen Kamm (211) gegenüberliegend eingerichtet ist, so dass, wenn sich der Verriegelungsmechanismus (500) in der entriegelten Anfangskonfiguration befindet, die Finger (223) des beweglichen Kamms (221) nicht zwischen die Finger (213) des festen Kamms (211) eingreifen, und sobald sich der Verriegelungsmechanismus (500) in der verriegelten Endkonfiguration befindet, die Finger (223) des beweglichen Kamms (221) zwischen die Finger (213) des festen Kamms (211) eingreifen und der Verriegelungsmechanismus (500) ein Lösen der Finger (223) des beweglichen Kamms (221) von zwischen den Fingern (213) des festen Kamms (211) verhindern,
**dadurch gekennzeichnet, dass** in der verriegelten Endkonfiguration der Verriegelungsmechanismus eine Verlagerung des beweglichen Antriebsteils (220) in Bezug auf den festen Antriebsteil (210) während des gesamten weiteren Betriebs des Aktuators (11) gestattet.

2. Mikrosystem nach Anspruch 1, wobei, wenn sich der Verriegelungsmechanismus (500) in der entriegelten Anfangskonfiguration befindet, die Finger (223) des beweglichen Kamms (221) von den Fingern (213) des festen Kamms (211) in einem ersten Abstand (G1) beabstandet sind, und wenn sich der Verriegelungsmechanismus (500) in der verriegelten Endkonfiguration befindet, die Finger (223) des beweglichen Kamms (221) von den Fingern (213) des festen Kamms (211) in einem zweiten Abstand (G2, G3) beabstandet sind, der kleiner als der erste Abstand (Gl) ist.

3. Mikrosystem nach einem der Ansprüche 1 und 2, wobei der zweite Abstand (G2, G3) zwischen 0,1 und 5 µm, vorzugsweise zwischen 1 und 3 µm, beträgt.

4. Mikrosystem nach einem der Ansprüche 1 bis 3, wobei ein Verhältnis zwischen einer Höhe der Finger (213, 223) und dem zweiten Abstand (G2, G3) zwischen den Fingern (213) des festen Kamms (211) und den Fingern (223) des beweglichen Kamms (221) zwischen 50 und 400, vorzugsweise zwischen 70 und 150, liegt.

5. Mikrosystem nach einem der Ansprüche 1 bis 4, wobei der Aktuator (11) einen Anschlag (240) umfasst, der, sobald sich der Verriegelungsmechanismus (500) in der verriegelten Endkonfiguration befindet, eine Verlagerung des ersten beweglichen Teils (220) verhindert, die dazu neigt, die Finger (223) des beweglichen Kamms (221) von zwischen den Fingern (213) des festen Kamms (211) zu lösen.

6. Mikrosystem nach Anspruch 5, wobei der Verriegelungsmechanismus (500) mindestens einen ersten Rastzapfen (512), der mit dem Anschlag (240) verbunden ist, und einen zweiten Rastzapfen (112), der mit dem Träger (6) verbunden ist, umfasst, wobei der erste Raststift (512) geeignet ist, mit dem zweiten Rastzapfen (112) in Eingriff gebracht zu werden, wenn der Verriegelungsmechanismus (500) in der verriegelten Endkonfiguration ist.

7. Mikrosystem nach Anspruch 6, wobei, sobald der erste Rastzapfen (512) mit dem zweiten Rastzapfen (112) in Eingriff ist, der erste Rastzapfen (512) und der zweite Rastzapfen (112) eine Rückkehr des Verriegelungsmechanismus in die entriegelte Anfangskonfiguration verhindern.

8. Mikrosystem nach einem der Ansprüche 1 bis 7, umfassend eine Aufhängung (230), die den beweglichen Antriebsteil (220) mit dem Träger (6) verbindet, und wobei der bewegliche Antriebsteil (220) imstande ist, in Bezug auf den festen Antriebsteil (210) in einer ersten Richtung (A) unter der Wirkung einer elektrostatischen Kraft, die durch Anlegen einer von Null verschiedenen Spannung zwischen dem festen Antriebsteil (210) und dem beweglichen Antriebsteil (220) erzeugt wird, verlagert zu werden, wobei die Verlagerung des beweglichen Antriebsteils (220) in Bezug auf den festen Antriebsteil (210) eine elastische Verformung der Aufhängung (230) bewirkt, und der bewegliche Antriebsteil (220) imstande ist, in Bezug auf den festen Antriebsteil (210) in einer zweiten Richtung (B), die der ersten Richtung (A) entgegengesetzt ist, wenn die angelegte Spannung abnimmt, unter der Wirkung einer elastischen Rückstellkraft, die von der elastisch verformten Aufhängung (230) erzeugt wird, verlagert zu werden, wobei die elastische Rückstellkraft der elektrostatischen Kraft entgegengesetzt ist.

9. Mikrosystem nach Anspruch 8, wobei der Verriegelungsmechanismus (500) einen Drücker (510) umfasst, wobei der Drücker (510) derart eingerichtet ist, dass, wenn der bewegliche Antriebsteil (220) zum ersten Mal in Bezug auf den festen Antriebsteil (210) in der ersten Richtung (A) verlagert wird, der bewegliche Antriebsteil (220) den Drücker (510) in die erste Richtung drückt, wodurch der Verriegelungsmechanismus (500) aus der entriegelten Anfangskonfiguration in die verriegelte Endkonfiguration wechselt.

10. Mikrosystem nach Anspruch 9, wobei der Verriegelungsmechanismus (500) einen flexiblen Balken (520) umfasst, der den Drücker (510) mit dem Träger verbindet, wobei der flexible Träger (520) unter der Wirkung der Verlagerung des Drückers (510) in der ersten Richtung (A) verformt wird.

## Claims

1. A microelectromechanical system (10), comprising a support (6) and an actuator (11), the actuator (11) comprising a drive module (200) comprising:
- a fixed drive portion (210), mounted fixedly on the support (6), and comprising a fixed comb (211) with fingers (213), and
- a movable drive portion (220) mounted movably relative to the support (6), and comprising a movable comb (221) with fingers (223),
- a latching mechanism (500) that is movable between an initial unlatched configuration and a final latched configuration,
wherein the movable comb (221) is arranged facing the fixed comb (211) so that when the latching mechanism (500) is in the initial unlatched configuration, the fingers (223) of the movable comb (221) are not engaged between the fingers (213) of the fixed comb (211), and once the latching mechanism (500) is in the final latched configuration, the fingers (223) of the movable comb (221) are engaged between the fingers (213) of the fixed comb (211) and the latching mechanism (500) prevents disengagement of the fingers (223) of the movable comb (221) from between the fingers (213) of the fixed comb (211),
**characterised in that** in the final locked configuration, the locking mechanism allows a movement of the movable drive portion (220) relative to the fixed drive portion (210) throughout the subsequent operation of the actuator (11).

2. The microsystem according to claim 1, wherein when the latching mechanism (500) is in the initial unlatched configuration, the fingers (223) of the movable comb (221) are spaced from the fingers (213) of the fixed comb (211) by a first spacing (G1), and when the latching mechanism (500) is in the final latched configuration, the fingers (223) of the movable comb (221) are spaced from the fingers (213) of the fixed comb (211) by a second spacing (G2, G3) less than the first spacing (G1).

3. The microsystem according to one of claims 1 and 2, wherein the second spacing (G2, G3) is comprised between 0.1 and 5 µm, preferably comprised between 1 and 3 µm.

4. The microsystem according to one of claims 1 to 3, wherein a ratio between a height of the fingers (213, 223) and the second spacing (G2, G3) between the fingers (213) of the fixed comb (211) and the fingers (223) of the movable comb (221) is comprised between 50 and 400, preferably comprised between 70 and 150.

5. The microsystem according to one of claims 1 to 4, wherein the actuator (11) comprises a stop (240) which, once the latching mechanism (500) is in the final latched configuration, prevents movement of the first movable portion (220) tending to disengage the fingers (223) of the movable comb (221) from between the fingers (213) of the fixed comb (211).

6. The microsystem according to claim 5, wherein the latching mechanism (500) comprises at least one first locking lug (512) connected to the stop (240) and a second locking lug (112) connected to the support (6), the first locking lug (512) being able to be engaged with the second locking lug (112) when the latching mechanism (500) is in the final latched configuration.

7. The microsystem according to claim 6, wherein once the first locking lug (512) is engaged with the second locking lug (112), the first locking lug (512) and the second locking lug (112) prevent a return of the latching mechanism to the initial unlatched configuration.

8. The microsystem according to one of claims 1 to 7, comprising a suspension (230) connecting the movable drive portion (220) to the support (6),
and wherein the movable drive portion (220) is able to be moved relative to the fixed drive portion (210) in a first direction (A), as a result of an electrostatic force generated by the application of a nonzero voltage between the fixed drive portion (210) and the movable drive portion (220), the movement of the movable drive portion (220) relative to the fixed drive portion (210) causing an elastic deformation of the suspension (230),
and the movable drive portion (220) is able to be moved relative to the fixed drive portion (210) in a second direction (B), opposite to the first direction (A), when the applied voltage decreases, as a result of an elastic return force generated by the suspension (230) having been deformed elastically, the elastic return force being opposed to the electrostatic force.

9. The microsystem according to claim 8, wherein the latching mechanism (500) comprises a tappet (510), the tappet (510) being arranged so that when the movable drive portion (220) is moved for the first time relative to the fixed drive portion (210) in the first direction (A), the movable drive portion (220) pushes the tappet (510) in the first direction, which has the effect of making the latching mechanism (500) pass from the initial unlatched configuration to the final latched configuration.

10. The microsystem according to claim 9, wherein the latching mechanism (500) comprises a flexible beam (520) connecting the tappet (510) to the support, the flexible beam (520) being deformed as a result of the movement of the tappet (510) in the first direction (A).
